(19) Europäisches Patentamt
European Patent Office
Office européen des brevets

(11) EP 4 541 587 A1

(12) **EUROPEAN PATENT APPLICATION**
published in accordance with Art. 153(4) EPC

(43) Date of publication:
**23.04.2025 Bulletin 2025/17**

(21) Application number: **23823982.6**

(22) Date of filing: **15.06.2023**

(51) International Patent Classification (IPC):
***B32B 27/30*** (2006.01) ***B32B 27/36*** (2006.01)
***B32B 27/40*** (2006.01) ***C08F 2/44*** (2006.01)
***C08F 283/02*** (2006.01) ***C08J 7/043*** (2020.01)

(52) Cooperative Patent Classification (CPC):
**B32B 27/30; B32B 27/36; B32B 27/40; C08F 2/44; C08F 283/02; C08J 7/043**

(86) International application number:
**PCT/JP2023/022293**

(87) International publication number:
**WO 2023/243692 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.06.2022 JP 2022096982**

(71) Applicant: **Toray Industries, Inc.**
**Tokyo 103-8666 (JP)**

(72) Inventors:
- **SAWAMOTO, Keiko**
  **Otsu-shi, Shiga 520-8558 (JP)**
- **MASUDA, Yoshihiro**
  **Otsu-shi, Shiga 520-8558 (JP)**
- **UTO, Takayuki**
  **Otsu-shi, Shiga 520-8558 (JP)**

(74) Representative: **Mewburn Ellis LLP**
**Aurora Building**
**Counterslip**
**Bristol BS1 6BX (GB)**

# (54) MULTILAYER FILM

(57) The present invention provides a multilayer film which has a resin layer in at least one surface, and which is characterized in that: the resin layer satisfies at least one of the features A to C described below; and if Xs and Xc are the positive secondary ion normalized intensities of GCIB-TOF-SIMS of each component at the positions corresponding to 20% and 50% of the thickness from the surface layer of the resin layer, all components satisfy 0.5 ≤ Xs/Xc ≤ 2.0. Feature A: All of an acrylic resin, a polyester resin and a urethane resin are contained. Feature B: An acrylic modified polyester resin and a urethane resin are contained. Feature C: All of an acrylic skeleton, a polyester skeleton and a urethane skeleton are contained. Consequently, the present invention provides a multilayer film which is excellent in terms of versatile adhesiveness to various functional materials, thereby achieving high adhesion to a functional material regardless of the temperature at which the multilayer film is used, in particular, in a low temperature environment (below the freezing point).

EP 4 541 587 A1

## Description

### TECHNICAL FIELD

The present invention relates to a laminated film. More specifically, the present invention relates to a laminated film to be used together with a functional material such as an ethylene-vinyl acetate copolymer, polyvinyl alcohol, or polyvinyl butyral in applications such as solar battery members, laminated glass, and polarizer protection.

### BACKGROUND ART

Studies on combining a film with another member with a functional material such as an ethylene-vinyl acetate copolymer (hereinafter EVA), polyvinyl alcohol (hereinafter PVA), or polyvinyl butyral (hereinafter PVB) interposed have been made in many applications. For example, in a back sheet of a solar battery, EVA is provided on a laminated film to constitute a solar battery cell. In laminated glass applications, a film is inserted between two sheets of glass, with PVB or EVA interposed, to form laminated glass. For polarizer protective film applications, it has been studied to provide films as protective layers on both surfaces of a polarizing PVA layer.

In particular, since photovoltaic power generation has attracted attention as a semi-permanent, pollution-free next generation energy source, solar batteries are rapidly spreading. In addition, to impart functions such as heat shielding property and display property to window glass of automobiles and building materials, laminated glass in which a functional film is inserted has also been studied. These members are often used outdoors, and are required to be able to be used without problems in various temperature environments such as high temperature and high humidity in summer or low temperature environments (below freezing point) in cold climates.

However, when a film and another functional material are combined as described above, adhesion between the film and the functional material becomes a problem, and for example, with films that have been conventionally studied, there is a problem that adhesion between a film and EVA, PVB, PVA, or the like is not sufficient. If such a functional material and a film are peeled off, the resultant becomes difficult to be applied as a final product.

For this problem, there is a method of providing a resin layer for improving adhesion on the surface of a film; a method of adding a water-soluble polymer such as PVA to the resin layer to approximate the surface energy to a counterpart functional material to be adhered (Patent Document 1), a method of forming a hydrophilic easily-adhesive layer by in-line coating in a process for producing a polyester film (Patent Document 2), a method of improving flexibility and moist-heat resistance of an easily adhesive layer (Patent Document 3), and the like have been proposed.

### PRIOR ART DOCUMENTS

### PATENT DOCUMENTS

Patent Document 1: Japanese Patent Laid-open Publication No. 2000-336309
Patent Document 2: Japanese Patent Laid-open Publication No. 2001-179913
Patent Document 3: Japanese Patent Laid-open Publication No. 2011-156848

### SUMMARY OF THE INVENTION

### PROBLEMS TO BE SOLVED BY THE INVENTION

However, as in Patent Document 1, the method of incorporating a water-soluble polymer in a coating film laminated on a film is to improve adhesiveness by approximating the surface free energy between the coating film and PVA, and there is a problem in versatility such as that even if the coating film has good adhesiveness to PVA having a specific saponification degree, adhesiveness to other PVA or the like differing in saponification degree deteriorates. Furthermore, since the coating film swells or shrinks depending on the operating temperature, there is also a problem that adhesiveness is deteriorated depending on the operating temperature. A method of laminating a hydrophilic easily-adhesive layer by in-line coating as in Patent Document 2 also has the same problem as the method of Patent Document 1. In addition, a method of improving the flexibility of an easily adhesive layer as in Patent Document 3 has a problem that the adhesiveness deteriorates depending on the operating temperature because the adhesiveness and hardness of the easily adhesive layer significantly change depending on the operating temperature.

As described above, in the conventional resin layers described in Patent Documents 1 to 3, versatile adhesiveness to various functional materials is not sufficient, and further, there is a problem that adhesiveness to functional

materials deteriorates particularly under a low temperature environment (below freezing point) assuming outdoor use.

To solve such a problem, a challenge of the present invention is to provide a laminated film which is superior in versatile adhesiveness to various functional materials and has high adhesiveness to functional materials regardless of the temperature at which the laminated film is used, in particular, in a low temperature environment (below freezing point).

SOLUTIONS TO THE PROBLEMS

As a result of intensive studies in view of the above problems, the present inventors have found that by use of a laminated film provided with a resin layer having specific physical characteristics, a laminated film having superior adhesiveness between a resin layer and a functional material provided on the resin layer can be obtained, and have accomplished the present invention. That is, the present invention has the following configurations.

A laminated film having a resin layer on at least one surface, wherein the resin layer satisfies at least one of the features A to C described below, and when positive secondary ion normalized intensities of GCIB-TOF-SIMS of each component at positions of 20% and 50% of the thickness from the surface layer of the resin layer are denoted by Xs and Xc, respectively, $0.5 \leq Xs/Xc \leq 2.0$ is satisfied for all components:

Feature A: all of an acrylic resin, a polyester resin and a urethane resin are contained;
Feature B: an acrylic modified polyester resin and a urethane resin are contained;
Feature C: all of an acrylic skeleton, a polyester skeleton and a urethane skeleton are contained.

EFFECTS OF THE INVENTION

According to the present invention, it is possible to provide a laminated film which is superior in versatile adhesiveness to various functional materials and has high adhesiveness to various functional materials regardless of the temperature at which the laminated film is used, in particular, in a low temperature environment (below freezing point).

EMBODIMENTS OF THE INVENTION

The laminated film of the present invention will be described in detail below, but the present invention is not construed as being limited to the embodiments including the following examples. Various embodiments are of course included in the scope of the present invention as long as the object of the invention can be achieved and those embodiments do not depart from the gist of the invention.

The laminated film of the present invention includes a resin layer on one surface. The film as referred to herein is a sheet-like molded body containing a thermoplastic resin as a main component, and the main component refers to a component contained in an amount of more than 50% by mass and 100% by mass or less in all constituent components, and can hereinafter be interpreted in the same manner. The material of the film is not particularly limited, and the thermoplastic resins to be used in the laminated film referred to above can be chain polyolefins such as polyethylene, polypropylene, poly(4-methylpentene-1), and polyacetal, alicyclic polyolefins that are produced from norbornene by ring-opening metathesis polymers, addition polymers, or addition copolymers with other olefins, biodegradable polymers such as polylactic acid and polybutyl succinate, polyamides such as nylon 6, nylon 11, nylon 12, and nylon 66, aramid, polymethyl methacrylate, polyvinyl chloride, polyvinylidene chloride, polyvinyl alcohol, polyvinyl butyral, an ethylene-vinyl acetate copolymer, polyacetal, polyglycolic acid, polystyrene, styrene-copolymerized polymethyl methacrylate, polyesters such as polycarbonate, polypropylene terephthalate, polyethylene terephthalate, polybutylene terephthalate, and polyethylene-2,6-naphthalate, polyethersulfone, polyetheretherketone, modified polyphenylene ether, polyphenylene sulfide, polyetherimide, polyimide, polyarylate, a tetrafluoroethylene resin, a trifluoroethylene resin, a trifluorochloroethylene resin, a tetrafluoroethylenehexafluoropropylene copolymer, and polyvinylidene fluoride. Among them, polyester is particularly preferably used from the viewpoint of being superior in such properties as mechanical properties, electrical properties, dimensional stability, transparency, and chemical resistance. These may be a copolymer or a mixture of two or more resins.

The laminated film refers to a film in which two or more layers differing in composition are laminated. In addition, the resin layer generally refers to a primer layer provided on a film surface, and is a layer provided for bonding the film and another member together.

Polyester is a general term for polymers having an ester linkage as a main bonding chain of a main chain, and one containing, as a main constituent component, at least one constituent component selected from ethylene terephthalate, propylene terephthalate, ethylene-2,6-naphthalate, butylene terephthalate, propylene-2,6-naphthalate, ethylene-α,β-bis(2-chlorophenoxy)ethane-4,4'-dicarboxylate, and the like can be preferably used. Here, the main constituent component refers to a constituent component (constituent unit) contained in an amount of more than 50 mol% and 100 mol% or less where an amount of all constituent components (constituent unit) constituting a polymer is 100 mol%. Hereinafter, a

film containing a polyester resin as a main component may be referred to as a polyester film.

The laminated film of the present invention preferably has a resin layer on a surface of a film for a substrate. The type of the film for a substrate is not particularly limited, but a polyester film is preferably used, and a polyethylene terephthalate film is more preferably used. In addition, when heat, shrinkage stress, or the like acts on the laminated film, it is preferable to use a polyethylene naphthalate film, which is superior in heat resistance and rigidity. Here, polyethylene terephthalate refers to a polyester containing ethylene terephthalate as a main constituent component, and the polyethylene terephthalate film refers to a film containing more than 50% by mass and 100% by mass or less of polyethylene terephthalate where the amount of all components constituting the film is 100% by mass. Polyethylene naphthalate and a polyethylene naphthalate film can be interpreted in the same manner.

In a case where a plurality of types of components corresponding to polyethylene terephthalate are present in a film, when the total amount thereof is more than 50% by mass and 100% by mass or less, the film is regarded as a polyethylene terephthalate film. Also in this regard, a polyethylene naphthalate film can be interpreted in the same manner.

The polyester film for a substrate is preferably a biaxially oriented polyester film. The biaxially oriented polyester film refers to a polyester film that exhibits a biaxially orientated pattern in wide angle X-ray diffraction. The biaxially oriented polyester film can be generally obtained by stretching an unstretched polyester sheet or film in two orthogonal directions (for example, a longitudinal direction and a width direction) and then completing crystal orientation by heat treatment. The draw ratio at this time is preferably 2.5 or more and 5.0 or less. Owing to the polyester film for a substrate being a biaxially oriented polyester film, the thermal stability of the laminated film, particularly, dimensional stability and mechanical strength are enhanced, and planarity is also improved. The longitudinal direction refers to a direction in which the film travels during the production process, and in a film roll state, a winding direction corresponds to the longitudinal direction. The width direction refers to a direction orthogonal to the longitudinal direction in a film surface.

In addition, various additives, for example, antioxidants, heat resistance stabilizers, weather resistance stabilizers, ultraviolet absorbing agents, organic easily slipping agents, pigments, dyes, organic or inorganic fine particles, fillers, antistatic agents, and nucleating agents may be added to the polyester film for a substrate to such an extent that properties thereof are not deteriorated. These components may be used in combination.

The thickness of the polyester film for a substrate is not particularly limited and is appropriately selected depending on the application and type, but is usually preferably 10 to 500 μm, more preferably 20 to 250 μm and most preferably 30 to 150 μm, from the viewpoint of mechanical strength, handleability, etc. Further, the polyester film for a substrate may be a composite film obtained by coextrusion, or may be a film obtained by laminating the obtained films by various methods.

The resin layer in the laminated film of the present invention satisfies at least one of features A to C from the viewpoint of enhancing versatile adhesiveness in a normal temperature environment and adhesiveness in a low temperature environment.

Feature A: All of an acrylic resin, a polyester resin and a urethane resin are contained.

Feature B: An acrylic modified polyester resin and a urethane resin are contained.

Feature C: all of an acrylic skeleton, a polyester skeleton and a urethane skeleton are contained.

From the above viewpoint, the laminated film satisfies $0.5 \leq Xs/Xc \leq 2.0$ for all the components when the positive secondary ion normalized intensities of GCIB-TOF-SIMS of the respective components at the positions of 20% and 50% of the thickness from the surface layer of the resin layer are Xs and Xc, respectively. Furthermore, from the above viewpoint, the laminated film of the present invention preferably satisfies $0.5 \leq Xb/Xc \leq 2.0$ for all components when a positive secondary ion normalized intensity of GCIB-TOF-SIMS of each component at a position of 80% of the thickness from the surface layer of the resin layer is Xb.

Here, the GCIB is an abbreviation for a gas cluster ion beam, and the TOF-SIMS is an abbreviation for time-of-flight secondary ion mass spectrometry. In the analysis by GCIB-TOF-SIMS, ions derived from an acrylic resin, a polyester resin, and a urethane resin are generated in the aspect of Feature A, and ions derived from an acrylic skeleton, a polyester skeleton, and a urethane skeleton are generated in the aspect of Feature C. Also in an embodiment in which an acrylic modified polyester resin is contained instead of the acrylic resin and the polyester resin (an embodiment satisfying Feature B), ions derived from acryl or polyester are generated. Therefore, all components refers here to an acrylic component, a polyester component, and a urethane component, and these components are detected as ions in analysis by GCIB-TOF-SIMS. As described above, since ions derived from acryl, polyester, and urethane are generated in the case where any aspect of Features A to C is satisfied, "all components" can be interpreted in the same manner in any aspect.

The resin layer in the laminated film of the present invention is required to satisfy at least one of Features A to C from the viewpoint of versatile adhesiveness to various functional materials. The "functional material" as used herein refers to a layer provided on the resin layer in the laminated film and having functions such as sealing, adhesiveness, designability, durability, weather resistance, and impact resistance. For example, a solar battery is generally configured by bonding a power generation element (solar battery cell), a transparent substrate such as glass, and a resin sheet called a back sheet (back surface protection sheet). When these members are bonded, a "sealant" having functions such as protection from an external environment such as infiltration of moisture into the solar battery cell and adhesiveness with the

back sheet may be used as a functional material. When the laminated film is bonded to glass or inserted between two sheets of glass to form a glass component, and then used, an "intermediate layer" having functions such as adhesiveness between glass and the laminated film, designability, durability, weather resistance, and impact resistance of a laminated glass may be used as a functional material. The sealant and the intermediate layer as the functional material are not particularly limited, but examples thereof include EVA, PVB, and PVA, and details thereof will be described later.

When the resin layer contains a urethane resin or a urethane skeleton, a hydrogen bond can be formed with a hydroxy group of EVA, PVB, PVA, or the like, and high adhesiveness can be exhibited. When the resin layer contains a polyester resin or a polyester skeleton, high adhesiveness to a functional materials such as EVA, PVB, or PVA due to a hydrogen bond with a hydroxy group can be realized, and when the substrate is a polyester film, adhesiveness to the substrate can also be improved. Owing to the fact that the resin layer contains an acrylic resin or an acrylic skeleton, curing of the resin layer is promoted when the resin layer is formed by coating, and a water droplet contact angle of the resin layer described later is easily adjusted to 65° or more and 90° or less.

In the laminated film of the present invention, also when the acrylic resin and the polyester resin are an acrylic modified polyester resin (in other words, when an acrylic modified polyester resin is contained instead of the polyester resin and the acrylic resin), the same effects as those of a laminated film containing a polyester resin and an acrylic resin or a laminated film containing a polyester skeleton and an acrylic skeleton can be obtained.

The resin layer in the laminated film of the present invention may contain the polyester resin and the urethane resin in the form of a polyester-urethane copolymer. A layer containing an acrylic resin and a polyester-urethane copolymer can be considered to satisfy both "layer containing all of an acrylic resin, a polyester resin, and a urethane resin" and "layer containing all of an acrylic skeleton, a polyester skeleton, and a urethane skeleton", i.e., Features A and **C,** and a layer containing an acrylic modified polyester resin and a polyester-urethane copolymer can be considered to satisfy both "layer containing an acrylic modified polyester resin and a urethane resin" and "layer containing all of an acrylic skeleton, a polyester skeleton, and a urethane skeleton", i.e., Features B and C.

In general, a functional material such as EVA, PVB, or PVA has a wide range of elastic modulus depending on the degree of saponification. In addition, even if such a functional material has a low elastic modulus and is relatively flexible under a normal temperature environment, the elastic modulus increases under a low temperature environment of, for example, -20°C, and the difference in elastic modulus from a normal temperature environment increases. Therefore, even if adhesion between the functional material and the resin layer is sufficient under a normal temperature environment, peeling is likely to occur at the interface between the functional materials and the resin layer under a low temperature environment. In the adhesiveness between the functional material having such a wide range of elastic modulus and the resin layer, the elastic modulus of the resin layer is important, and it is known that the adhesiveness deteriorates as the elastic modulus of the resin layer increases (in other words, as the resin layer becomes harder). On the other hand, similarly to the case where the elastic modulus of the functional material increases under a low temperature environment of -20°C, the elastic modulus of the resin layer also generally increases under a low temperature environment.

In controlling the elastic modulus of the resin layer, it is important to mix resins differing in elastic modulus. An acrylic resin, a polyester resin, a urethane resin, an acrylic modified polyester resin, and a polyester-urethane copolymer usually differ from each other in elastic modulus. More specifically, since a polyester resin generally has a high elastic modulus, a urethane resin has a low elastic modulus, and an acrylic resin has an intermediate elastic modulus, the elastic modulus can be easily controlled by mixing these three types of resins. However, for example, in the case of a urethane resin, an aliphatic urethane resin containing an aliphatic moiety as a part of the constitution and an aromatic urethane resin containing an aromatic moiety as a part of the constitution are different in elastic modulus depending on the skeleton constituting each resin, such as the elastic modulus of the aromatic urethane resin becomes higher with the rigidity of an aromatic chain. Therefore, the elastic moduli of the polyester resin, the acrylic resin, and the urethane resin may not necessarily be in this order as described above. In addition, the acrylic modified polyester resin has characteristics of an acrylic resin and characteristics of a polyester resin, and the polyester-urethane copolymer has characteristics of a polyester resin and characteristics of a urethane resin. Therefore, the acrylic modified polyester resin and the polyester-urethane copolymer generally each have an intermediate elastic modulus.

As described above, the resin layer needs to satisfy at least one of Features A to C from the viewpoint of enhancing versatile adhesiveness and adhesiveness under a low temperature environment, but on the other hand, the acrylic resin, the polyester resin, and the urethane resin are different from each other in properties, namely, considering their skeletons, the acrylic resin is hydrophobic, whereas the polyester resin and the urethane resin are hydrophilicity in order. In general, it is known that when a hydrophobic resin and a hydrophilic resin are mixed to form a resin layer, a distribution occurs in the depth direction for each resin having each property. Therefore, when these three types of resins are simply mixed, for example, the proportion of the acrylic resin is large on the surface layer side of the resin layer, and the proportion of the polyester resin or the urethane resin is large on the inner layer side, so that the component distribution is biased in the resin layer. Such a component distribution bias occurs also between the acrylic modified polyester resin and the urethane resin and between the acrylic modified polyester resin and the polyester-urethane copolymer.

Then, as a result of intensive studies, the inventors have found that when the resin layer is designed to satisfy at

least one of Features A to C and $0.5 \leq Xs/Xc \leq 2.0$ is satisfied for all components when the positive secondary ion normalized intensities of GCIB-TOF-SIMS of each component at the positions of 20% and 50% of the thickness from the surface layer of the resin layer are denoted by Xs and Xc, respectively, superior flexibility is attained under a normal temperature environment, an increase in elastic modulus under a low temperature environment is inhibited, and superior adhesiveness can be exhibited under any environment. Further, in the laminated film of the present invention, it is also preferable that $0.5 \leq Xb/Xc \leq 2.0$ is satisfied for all components when the positive secondary ion normalized intensity of GCIB-TOF-SIMS of each component at the position of 80% of the thickness from the surface layer of the resin layer is Xb.

The fact that the laminated film of the present invention satisfies $0.5 \leq Xs/Xc \leq 2.0$ means that each component is uniformly dispersed from the vicinity of the surface of the resin layer to the central portion of the resin layer, and the fact that $0.5 \leq Xb/Xc \leq 2.0$ is satisfied means that each component is uniformly dispersed from the central portion of the resin layer to the vicinity of another layer (for example, a layer formed of a film for a substrate). That is, the fact that both Xs/Xc and Xb/Xc are within the above ranges mean that each component is uniformly dispersed in the thickness (depth) direction of the resin layer. Conversely, when neither Xs/Xc nor Xb/Xc satisfies the above ranges, this means that there is a bias in the dispersion state of each component in the depth direction in the resin layer.

It is particularly important that the resin layer satisfies $0.5 \leq Xs/Xc \leq 2.0$ for all components because this requirement greatly contributes to adhesion to the functional material. Furthermore, a case where the resin layer satisfies $0.5 \leq Xb/Xc \leq 2.0$ for all the components is preferable because the entire resin layer is uniform, sufficient adhesiveness under a normal temperature environment can be easily obtained, and deterioration in adhesiveness at a low temperature can be easily reduced.

Xs, Xc, and Xb of the resin layer can be measured by GCIB-TOF-SIMS, and specific measurement methods and conditions will be described later. The "position of 20% of the thickness from the surface layer of the resin layer" refers to a position corresponding to 20% where the surface of the resin layer is 0% and the interface between the resin layer and another layer is 100%. The "position of 50% of the thickness from the surface layer of the resin layer" and the "position of 80% of the thickness from the surface layer of the resin layer" can be interpreted in a similar manner.

Preferably, the laminated film of the present invention satisfies at least one of Features A to C, and a compound having both hydrophobicity and hydrophilicity is incorporated. By adopting such an aspect, it is possible to suppress the bias of the distribution of each component in the depth direction and to form a more uniform resin layer. When each component is more uniformly dispersed in the thickness direction, the elastic modulus of the entire resin layer becomes more uniform, the versatile adhesiveness to various functional materials is improved, and high adhesiveness can be realized even under a low temperature environment.

In addition, the laminated film of the present invention preferably has at least one of the following Features 1 and 2 when the AFM elastic modulus at a temperature T°C of the resin layer measured with an atomic force microscope (hereinafter referred to as AFM) is denoted by P(T), P(-20) - P(25) is denoted by $\Delta P$, and P(-20)/P(25) is an elastic modulus ratio P'.

Feature 1: $\Delta P$ is 0.2 GPa or more and 2.0 GPa or less.

Feature 2: The elastic modulus ratio P' is 0.1 or more and 2.3 or less.

The AFM elastic modulus of the resin layer can be measured using a known measuring apparatus, for example, NanoScope V manufactured by Bruker AXS. A measurement method and procedure using this apparatus will be described later. P(-20) is an AFM elastic modulus at -20°C, and indicates an AFM elastic modulus under a low temperature environment assuming use in cold regions or desert areas. On the other hand, P(25) is an AFM elastic modulus at 25°C, namely, under a normal temperature environment. In general, it is known that the elastic modulus of a functional material such as EVA, PVB, or PVA increases under a low temperature environment of -20°C, and the adhesiveness between the resin layer and the functional material as an adherend deteriorates as the elastic modulus of the functional material increases. Therefore, even when adhesion between a functional material such as EVA, PVB, or PVA and a resin layer is sufficient under a normal temperature environment, peeling tends to easily occur at an interface between the functional material and the resin layer under a low temperature environment.

In the case where the laminated film of the present invention does not have Feature 2, when $\Delta P$ is 0.2 GPa or more, the state change of the resin layer due to the temperature when the laminated film undergoes a thermal processing step with a functional material becomes sufficient, and the adhesiveness between the laminated film and the functional material is improved. When the laminated film of the present invention does not have Feature 2 and $\Delta P$ is 2.0 or less, an increase in elastic modulus at -20°C is controlled, and a decrease in adhesiveness to a functional material due to excessive curing of the resin layer is reduced. From the above viewpoint, a more preferable range of $\Delta P$ is 0.3 GPa or more and 1.7 GPa or less, and still more preferably 0.4 GPa or more and 1.3 GPa or less. In the conventional techniques described in Patent Documents 1 to 3, even if adhesiveness at 25°C is sufficient, there is a case where the elastic modulus of the adhesive layer changes at -20°C, and sufficient adhesiveness cannot be maintained.

In the case where the laminated film of the present invention does not have Feature 1, when the elastic modulus ratio P' is 0.1 or more, an increase in elastic modulus at -20°C is suppressed, and a decrease in adhesiveness to a functional material due to excessive curing of the resin layer is reduced. In addition, owing to the fact that the laminated film

of the present invention does not have Feature 1 and the elastic modulus ratio P' is 2.3 or less, the state change of the resin layer due to the temperature thereof when the laminated film undergoes the thermal processing step with a functional material is sufficient, and the adhesiveness between the laminated film and the functional material is improved. In addition, a preferable range of the elastic modulus ratio P' is 0.9 or more and 2.1 or less, and more preferably 1.1 or more and 2.0 or less because the film for a substrate, which is generally a sheet-like molded body containing a thermoplastic resin as a main component, comes to have an elastic modulus higher than that at 25°C when cooled to -20°C, or has a close value of elastic modulus before and after cooling. When the elastic modulus ratio P' is adjusted within the above range, it tends to be possible to further inhibit a decrease in adhesiveness to the functional material under a low temperature environment.

The laminated film of the present invention may have at least one of Features 1 and 2 from the viewpoint of enhancing the adhesiveness of the resin layer to the functional material in a low temperature environment, but it is more preferable to include both of features 1 and 2. By having both of Features 1 and 2, it is easy not only to reduce a decrease in adhesiveness to the functional material in a low temperature environment but also to make sufficient adhesiveness to the functional material in a normal temperature environment. Examples of the method for providing at least one of Features 1 and 2 or setting each of Features 1 and 2 to the above preferable range include a method of adjusting the glass transition temperature of the resin layer. More specifically, by adjusting the glass transition temperature of the resin layer to 30°C or higher, it is easy to reduce $\Delta P$ or to adjust the elastic modulus ratio P' to a suitable range. In addition, also when the resin layer A contains an oxazoline compound or a chemical structure derived from an oxazoline compound, it is easy to reduce $\Delta P$ or to adjust the elastic modulus ratio P' to a suitable range.

In the laminated film of the present invention, P(25) is preferably 0.2 GPa or more and 1.5 GPa or less. By adopting such an aspect, adhesiveness between the resin layer A of the laminated film of the present invention and a highly flexible functional material can be enhanced. From the above viewpoint, P(25) is more preferably 0.2 GPa or more and 1.3 GPa or less, and still more preferably 0.3 GPa or more and 0.9 GPa or less. When P(25) is 1.5 GPa or less, the resin layer is sufficiently flexible, and adhesion to a highly flexible functional material can be secured. When P(25) is adjusted to 0.2 GPa or more, the resin layer is not excessively flexible and blocking of the film having been wound up into a roll form can be reduced.

The method for adjusting P(25) to 0.2 GPa or more and 1.5 GPa or less or to the above preferable range is not particularly limited, and examples thereof include a method of adjusting the glass transition temperature of the resin layer. An alternative example is a method involving employing an aliphatic urethane resin or a resin obtained by polymerizing an aliphatic polyisocyanate compound with a polyol compound as the urethane resin to be contained in the resin composition that forms the resin layer satisfying Features A and B. Further, adjusting the content of the urethane resin to 4% by mass or more and 60% by mass or less, and preferably 4% by mass or more and 50% by mass or less based on 100% by mass of the resin composition makes it easy to adjust P(25) to 0.2 GPa or more and 1.5 GPa or less or to the above preferable range. Regarding the above points, in the case of having a resin layer that satisfies Feature C, the same interpretation can be made by replacing the urethane resin with a urethane skeleton. When a polyester-urethane copolymer is used as the urethane resin, the amount of the polyisocyanate compound charged at the time of copolymerization is defined as the content of the urethane resin.

In the laminated film of the present invention, the glass transition temperature (hereinafter, also referred to as Tg) of the resin layer is preferably 30°C or higher and 80°C or lower. When the Tg of the resin layer is 30°C or higher, an increase in $\Delta P$ is suppressed, and when the Tg of the resin layer is 80°C or lower, adhesiveness to a functional material can be sufficiently secured regardless of a temperature environment or a type. From the above viewpoint, Tg of the resin layer is more preferably 30°C or higher and 70°C or lower, and still more preferably 30°C or higher and 55°C or lower. The glass transition temperature of the resin layer can be measured with a differential scanning calorimeter (DSC), and the conditions and the like will be described later in detail in Examples.

The glass transition temperature can be adjusted by adjusting components contained in the resin layer. When the resin layer satisfies Feature B, the glass transition temperature of the resin layer can also be adjusted by adjusting the constitutional ratio of the acrylic resin component (acrylic unit) and the polyester resin component (polyester unit) in the acrylic modified polyester resin.

In the laminated film of the present invention, the water droplet contact angle of the resin layer is preferably 65° or more and 90° or less. By adopting such an aspect, a difference in hydrophilicity between the resin layer and a functional material is reduced, so that adhesiveness between the resin layer and the functional material can be enhanced. From the above viewpoint, the water droplet contact angle of the resin layer is more preferably 65° or more and 85° or less, and still more preferably 65° or more and 80° or less. The water droplet contact angle referred to in the present invention is one determined by the static drop method described in JIS R3257:1999. More specifically, it is a value that can be obtained by the following equation when a water droplet is placed on the surface of the resin layer and is in equilibrium under the atmosphere, and generally serves as an index for determining the wettability of the solid surface. That is, the smaller the value of the water droplet contact angle, the better the wettability of the solid surface, whereas the larger the value, the poorer the wettability. The following equation is called "Young's equation", and in this equation, an angle formed by a liquid surface and a solid surface is defined as a "contact angle". A specific method of measuring the water droplet contact angle

will be described later.

$$\gamma S = \gamma L\cos\theta + \gamma SL$$

wherein $\gamma S$ represents surface tension of the solid, $\gamma L$ represents surface tension of the liquid, $\gamma SL$ represents interfacial tension of the solid/the liquid, and $\theta$ represents a contact angle.

The method for adjusting the water droplet contact angle of the resin layer to 65° or more and 90° or less or to fall within the above preferable range is not particularly limited, but examples thereof include a method involving adjusting the ratio of a highly hydrophobic component or skeleton accounting for in the resin layer. For example, by increasing the ratio of the acrylic resin (aspect satisfying Feature A), the ratio of the acrylic skeleton (aspect satisfying Feature C), and the ratio of the acrylic modified polyester resin (aspect satisfying Feature B), the water droplet contact angle of the resin layer can be increased. In the aspect satisfying Feature B, the water droplet contact angle of the resin layer can be increased by increasing the ratio of the acrylic resin component (acrylic unit) accounting for in the acrylic modified polyester resin. As another method, a method of adding an oxazoline compound to the resin layer to increase the water droplet contact angle of the resin layer can also be used. These methods may be used appropriately in combination.

When the resin layer satisfies at least one of Features A and B, the urethane resin contained in the resin layer is preferably an aliphatic urethane resin, and more preferably an alicyclic urethane resin. Here, the aliphatic urethane resin refers to a urethane resin having an aliphatic chain, and the alicyclic urethane resin refers to an aliphatic urethane resin in which a part of the aliphatic chain has a cyclic structure. Since the alicyclic urethane resin is high in glass transition point among aliphatic urethane resins, the resin layer containing the alicyclic urethane resin is not softened or melted by heat added in a heat processing step such as fabrication of a laminated glass or in use under a high temperature and high humidity environment, and occurrence of bleeding out of oligomers in the polyester film to the surface of the resin layer is suppressed. Therefore, when the resin layer contains an alicyclic urethane resin, it is possible to obtain a resin layer superior in adhesiveness particularly under a moist-heat resistant environment. Regarding the above points, in the aspect where the resin layer satisfies Feature C, the same interpretation can be made by replacing the urethane resin with a urethane skeleton.

On the other hand, in the case where the resin layer satisfies at least one of Features A and B, when an aromatic urethane resin containing an aromatic in a part of the structure thereof is applied instead of the aliphatic urethane resin, the resin composition having an aromatic urethane resin cannot follow the expansion and contraction of EVA or PVB because the resin layer becomes rigid due to the influence of the aromatic chain, and sufficient adhesiveness may not be obtained. In addition, when the resin layer is irradiated with light, problems such as yellowing and embrittlement of the resin layer may occur, and for example, in use for hot-wire cut glass or window glass, the quality may deteriorate due to the influence of external light. Regarding the above points, in the aspect where the resin layer satisfies Feature C, the same interpretation can be made by replacing the urethane resin with a urethane skeleton.

The acrylic modified polyester resin that can be used in the laminated film of the present invention (aspect satisfying Feature B) is one in which an acrylic resin component and a polyester resin component are bonded to each other, and includes, for example, a graft polymerization type and a block copolymerization type. As to the copolymerization proportion of the acrylic resin component and that of the polyester resin component in the acrylic modified polyester resin, either one may be higher. The acrylic modified polyester resin can be produced, for example, by adding a radical initiator to both terminals of a polyester and polymerizing an acrylic monomer, by adding a radical initiator to a side chain of a polyester and polymerizing an acrylic monomer, or by adding a hydroxy group to a side chain of an acrylic resin and reacting the resulting acrylic resin with a polyester having an isocyanate group or a carboxyl group at a terminal. As described above, it is preferable that the acrylic resin component and the polyester resin component are bonded to each other from the viewpoint of the stability of the resin layer.

When the amount of the acrylic resin component in the acrylic modified polyester resin is increased, the water droplet contact angle of the resin layer can be increased, whereas when the amount of the acrylic resin component is reduced, the water droplet contact angle of the resin layer can be reduced. A measure to adjust the water droplet contact angle of the resin layer to the range of 65° or more and 90° or less to be described later may be adjusting the mass ratio of the acrylic resin to the polyester resin (the content of the acrylic resin [parts by mass]/the content of the polyester resin [parts by mass]) or the mass ratio of the acrylic resin component to the polyester resin component in the acrylic modified polyester resin (the content of the acrylic resin component [parts by mass]/the content of the polyester resin component [parts by mass]) to 15/85 or more and 85/15 or less.

In particular, when a polyester film is used as the substrate of the laminated film of the present invention, the adhesiveness between the resin layer and the polyester film as the substrate can be improved by the polyester resin component of the acrylic modified polyester resin. As a method for adjusting the water droplet contact angle of the resin layer to 65° or more and 90° or less, a method of adjusting the amount of the oxazoline compound to 30 parts by mass or

more and 90 parts by mass or less where the total amount of the acrylic resin, the polyester resin, and the urethane resin (or the acrylic modified polyester resin and the urethane resin) is 100 parts by mass may also be used.

In addition, it is preferable that the resin layer has at least one or more structures of the following Formulas (1) to (5), and it is particularly preferable that the acrylic modified polyester resin has at least one or more structures of Formulas (1) to (5). Formulae (1) to (5) are polar groups that form a hydrogen bond with a hydroxy group of a functional material. Therefore, adopting such an aspect makes the resin layer possible to form hydrogen bonds with EVA, PVB, or PVA even at the moieties of Formulas (1) to (5), and can improve the adhesiveness with the functional material.

[Chem. 1]

Formula (1) 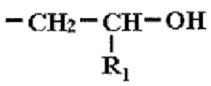

$R_1$ : H or $CH_3$

Formula (2) 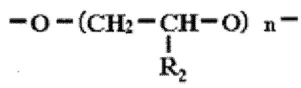

$R_2$ : H or $CH_3$, n : positive integer

Formula (3) 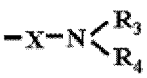

X : -C(=O)- or $CH_2$

$R_3$、$R_4$ : H, $CH_3$, $C_2H_5$, $CH(CH_3)_2$ or $CH_2OH$

Formula (4) 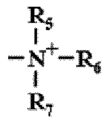

$R_5$、$R_6$、$R_7$ : $CH_3$ or $C_2H_5$

Formula (5) 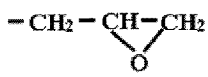

In the acrylic resin component constituting the acrylic modified polyester resin, specifically, a hydrophilic radically polymerizable vinyl monomer is preferably polymerized in the main chain of an acrylic resin constituted of alkyl methacrylate and/or alkyl acrylate. When the hydrophilic radically polymerizable vinyl monomer is contained in the acrylic resin component, at least one or more structures represented by Formulas (1) to (5) can be imparted to the acrylic modified polyester.

The amount of the hydrophilic radically polymerizable vinyl monomer is preferably 20 parts by mass or more and 50 parts by mass or less where the total amount of the acrylic resin component is 100 parts by mass. Adjusting the amount of the hydrophilic radically polymerizable vinyl monomer to 20 parts by mass or more and 50 parts by mass or less makes it easy to adjust the water droplet contact angle to the range of 65° or more and 90° or less, and can effectively improve the adhesiveness to a functional material.

As the acrylic resin component, an alkyl methacrylate and/or an alkyl acrylate is used, and specifically, it is preferable to use methacrylic acid, methyl methacrylate, ethyl methacrylate, isopropyl methacrylate, n-butyl methacrylate, isobutyl methacrylate, n-hexyl methacrylate, lauryl methacrylate, 2-hydroxyethyl methacrylate, hydroxypropyl methacrylate, acrylic acid, methyl acrylate, ethyl acrylate, isopropyl acrylate, n-butyl acrylate, isobutyl acrylate, n-hexyl acrylate, lauryl acrylate, 2-ethylhexyl acrylate, or the like. These can be used singly or in combination of two or more kinds thereof.

As to the hydrophilic radically polymerizable vinyl monomer, specific examples of the monomer to afford a structure of the above Formula (1) include hydroxyacrylic acid esters such as 2-hydroxyethyl acrylate, 2-hydroxyethyl methacrylate, hydroxypropyl acrylate, and hydroxypropyl methacrylate. Examples of the monomer to afford a structure of the above Formula (2) include glycol esters such as ethylene glycol acrylate, ethylene glycol methacrylate, polyethylene glycol acrylate, and polyethylene glycol methacrylate. Examples of the monomer to afford a structure of the above Formula (3) include acrylamide compounds such as acrylamide, methacrylamide, N-methylolacrylamide, and methoxymethylolacrylamide. Examples of the monomer to afford a structure of Formula (4) include cationic monomers such as aminoalkyl acrylate, aminoalkyl methacrylate, and quaternary ammonium salts thereof. Examples of the monomer to afford a structure of Formula (5) include glycidyl acrylate-based compounds such as glycidyl acrylate and glycidyl methacrylate, and unsaturated acids and salts thereof such as acrylic acid, methacrylic acid, maleic anhydride, itaconic acid, and crotonic acid. The hydrophilic radically polymerizable monomer may be used singly or several types thereof may be used in combination. Furthermore, other copolymerizable vinyl monomers may be used in combination with these hydrophilic monomers.

Examples of such other copolymerizable vinyl monomers include vinyl esters such as vinyl acetate and vinyl propionate, vinyl halides such as vinyl chloride and vinyl bromide, unsaturated carboxylic acid esters such as methyl acrylate, ethyl acrylate, butyl acrylate, methyl methacrylate, ethyl methacrylate, and butyl methacrylate, vinylsilanes such as dimethylvinylmethoxysilane and γ-methacryloxypropyltrimethoxysilane, olefins and diolefin compounds such as ethylene, propylene, styrene, and butadiene.

The polyester resin component constituting the acrylic modified polyester resin has an ester linkage in the main

chain or a side chain, and is constituted of a dicarboxylic acid component and a diol component. As the carboxylic acid component constituting the polyester resin, aromatic, aliphatic, or alicyclic dicarboxylic acids and trivalent or higher polyvalent carboxylic acids can be used. As the aromatic dicarboxylic acid, terephthalic acid, isophthalic acid, orthophthalic acid, phthalic acid, 2,5-dimethylterephthalic acid, 5-sodium sulfoisophthalic acid, 1,4-naphthalenedicarboxylic acid, and the like, and ester-forming derivatives thereof can be used.

As the glycol component of the polyester resin, ethylene glycol, diethylene glycol, polyethylene glycol, propylene glycol, polypropylene glycol, 1,3-propanediol, 1,3-butanediol, 1,4-butanediol, neopentyl glycol, and the like can be used.

When the polyester resin component is dissolved or dispersed in an aqueous solvent to be used as an aqueous resin composition, it is preferable to copolymerize a compound containing a sulfonate group or a compound containing a carboxylate group in order to facilitate solubilization in water or dispersion in water of the polyester resin component.

Examples of the compound containing a carboxylate group include, but are not limited to, alkali metal salts, alkaline earth metal salts, and ammonium salts of trimellitic acid, trimellitic anhydride, pyromellitic acid, pyromellitic anhydride, 4-methylcyclohexene-1,2,3-tricarboxylic acid, trimesic acid, 1,2,3,4-butanetetracarboxylic acid, 1,2,3,4-pentanetetracarboxylic acid, and the like.

Examples of compounds that can be used as the compound containing a sulfonate group include, but are not limited to, alkali metal salts, alkaline earth metal salts, and ammonium salts of sulfoterephthalic acid, 5-sulfoisophthalic acid, 5-sodium sulfoisophthalic acid, 4-sulfoisophthalic acid, and the like.

The acrylic modified polyester resin to be used for the resin composition that forms the resin layer of the present invention can be produced, for example, by the following production method. First, a polyester resin component is produced as follows. For example, the polyester resin component can be produced by a method in which a dicarboxylic acid component and a glycol component are directly subjected to an esterification reaction, or a method in which the polyester resin component is produced via a first stage step of making a dicarboxylic acid component and a glycol component undergo a transesterification reaction, and a second stage step of making the reaction product of the first stage undergo a polycondensation reaction. At this time, as a reaction catalyst, for example, an alkali metal, an alkaline earth metal, manganese, cobalt, zinc, antimony, germanium, or a titanium compound can be used.

Next, the polyester resin component is dispersed in a solvent. In particular, as a means for dispersing the polyester resin component in an aqueous solvent, the polyester resin is dissolved or dispersed in an aqueous solution of an alkaline compound such as aqueous ammonia, sodium hydroxide, potassium hydroxide, or various amines under stirring. In this case, a water-soluble organic solvent such as methanol, ethanol, isopropanol, butyl cellosolve, or ethyl cellosolve may be used in combination.

Subsequently, to produce an acrylic modified polyester resin, a polymerization initiator and, if necessary, an emulsifying dispersant or the like are added to the dispersion of the polyester resin component, and the acrylic resin component is gradually added while the temperature is kept constant, and then the mixture is reacted for several hours to produce a dispersion of an acrylic modified polyester. The resulting dispersion is a mixture of the acrylic modified polyester resin component, the polyester resin component, and the acrylic resin component.

The polymerization initiator is not particularly limited, and common radical polymerization initiators, for example, water-soluble peroxides such as potassium persulfate, ammonium persulfate, and hydrogen peroxide, oil-soluble peroxides such as benzoyl peroxide and t-butyl hydroperoxide, or azo compounds such as azodiisobutyronitrile can be used.

When the resin layer satisfies at least one of Features A and B, the urethane resin contained in the resin composition that forms the resin layer in the laminated film of the present invention is preferably an aliphatic urethane resin. The urethane resin used in the present invention is not particularly limited, but is preferably one obtained by polymerizing an aliphatic polyisocyanate compound and a polyol compound. When the resin layer satisfies Feature C, it is preferable that the urethane resin has a skeleton of a urethane resin suitable for a case where the resin layer satisfies at least one of Features A and B.

First, the aliphatic polyisocyanate compound used for the resin composition will be described. The aliphatic polyisocyanate compound preferably used for the resin composition is preferably one having a plurality of isocyanate groups in the molecule, and examples thereof include 1,6-hexane diisocyanate, isophorone diisocyanate, methylene-bis(4-cyclohexyl isocyanate), 2,2,4-trimethylhexamethylene diisocyanate, 1,4-hexamethylene diisocyanate, bis(2-isocyanatoethyl) fumarate, bis(4-isocyanatecyclohexyl)methane, dicyclohexylmethane 4,4-diisocyanate lysine diisocyanate, hydrogenated xylylene diisocyanate, and hydrogenated phenylmethane diisocyanate. The aliphatic polyisocyanate compound used in the present invention may be of either a single kind or two or more kinds.

In the present invention, any of the above-described aliphatic polyisocyanate compounds can be suitably used, and among them, an alicyclic polyisocyanate compound is preferably used. The aliphatic urethane resin polymerized from the alicyclic polyisocyanate compound has a high glass transition point among the aliphatic urethane resins. Therefore, such an aliphatic urethane resin is not softened or melted in the resin layer by the heat added when a functional material is laminated or to be applied under a high temperature and high humidity environment, so that the aliphatic urethane resin does not bleed out to the surface of the resin layer and can exist in the resin layer without being changed. Therefore, the

adhesiveness between the resin layer and the functional material can be maintained particularly in moist-heat resistant adhesion evaluation.

Next, the polyol compound used for the resin composition will be described. The polyol compound used for the resin composition is not particularly limited as long as it has a plurality of hydroxy groups. Examples of such a polyol compound include aromatic polyether polyol, aliphatic polyether polyol, polyester polyol, polycarbonate polyol, and polycaprolactone polyol. Hereinafter, specific examples of these polyol compounds will be described in order.

Examples of the aromatic polyether polyol include an ethylene oxide-added diol of bisphenol A, a propylene oxide-added diol of bisphenol A, a butylene oxide-added diol of bisphenol A, an ethylene oxide-added diol of bisphenol F, a propylene oxide-added diol of bisphenol F, a propylene oxide-added diol of bisphenol F, an alkylene oxide-added diol of hydroquinone, and an alkylene oxide-added diol of naphthoquinone.

Examples of the aliphatic polyether polyol include polyethylene glycol, polypropylene glycol, polytetramethylene glycol, 1,2-polybutylene glycol, polyisobutylene glycol, a copolymer polyol of propylene oxide and tetrahydrofuran, a copolymer polyol of ethylene oxide and tetrahydrofuran, a copolymer polyol of ethylene oxide and propylene oxide, a copolymer polyol of tetrahydrofuran and 3-methyltetrahydrofuran, and a copolymer polyol of ethylene oxide and 1,2-butylene oxide. Among the aliphatic polyether polyols, examples of the alicyclic polyether polyol include an ethylene oxide-added diol of hydrogenated bisphenol A, a propylene oxide-added diol of hydrogenated bisphenol A, a butylene oxide-added diol of hydrogenated bisphenol A, an ethylene oxide-added diol of hydrogenated bisphenol F, a propylene oxide-added diol of hydrogenated bisphenol F, a propylene oxide-added diol of hydrogenated bisphenol F, a dimethylol compound of dicyclopentadiene, and tricyclodecane dimethanol.

Examples of the polyester polyol include polyester polyols obtained by reacting a polyhydric alcohol such as ethylene glycol, polyethylene glycol, propylene glycol, polypropylene glycol, tetramethylene glycol, polytetramethylene glycol, 1,6-hexanediol, neopentyl glycol, 1,4-cyclohexanedimethanol, 3-methyl-1,5-pentanediol, 1,9-nonanediol, or 2-methyl-1,8-octanediol with a polybasic acid such as phthalic acid, isophthalic acid, terephthalic acid, maleic acid, fumaric acid, adipic acid, or sebacic acid.

Examples of the polycarbonate polyol include 1,6-hexane polycarbonate.

Examples of the polycaprolactone polyol include polycaprolactone diols obtained by reacting ε-caprolactone with a divalent diol such as ethylene glycol, polyethylene glycol, propylene glycol, polypropylene glycol, tetramethylene glycol, polytetramethylene glycol, 1,2-polybutylene glycol, 1,6-hexanediol, neopentyl glycol, 1,4-cyclohexanedimethanol, or 1,4-butanediol.

In addition, examples of the polyol compound that can be used for the resin composition include ethylene glycol, propylene glycol, 1,4-butanediol, 1,5-pentanediol, 1,6-hexanediol, neopentyl glycol, 1,4-cyclohexanedimethanol, polyβ-methyl-δ-valerolactone, hydroxy-terminated polybutadiene, hydroxy-terminated hydrogenated polybutadiene, castor oil-modified polyol, polydimethylsiloxane terminal diol compounds, and polydimethylsiloxane carbitol-modified polyol.

In the resin composition, any of these polyol compounds can be suitably used, and among them, aliphatic polyether polyol is preferably used. Since the aliphatic urethane resin can be made flexible by using the aliphatic polyether polyol, it becomes easier to adjust the P(25) described above to 0.2 GPa or more and 1.5 GPa or less, and it becomes possible to improve versatile adhesiveness to EVA, PVB, or PVA under a normal temperature environment. The polyol compound used in the resin composition may be of either a single kind or two or more kinds.

From the above points of view, the specific structure of the urethane resin used in the resin composition is particularly preferably constituted of the following aliphatic polyisocyanate compound and aliphatic polyether polyol. Examples of the aliphatic polyisocyanate compound include 1,6-hexane diisocyanate, isophorone diisocyanate, methylenebis(4-cyclohexyl isocyanate), 2,2,4-trimethylhexamethylene diisocyanate, 1,4-hexamethylene diisocyanate, bis(2-isocyanatoethyl) fumarate, bis(4-isocyanatecyclohexyl)methane, dicyclohexylmethane 4,4-diisocyanate lysine diisocyanate, hydrogenated xylylene diisocyanate, and hydrogenated phenylmethane diisocyanate.

Examples of the aliphatic polyether polyol include polyethylene glycol, polypropylene glycol, polytetramethylene glycol, 1,2-polybutylene glycol, and polyisobutylene glycol.

The aliphatic urethane resin to be used for the resin composition is a resin obtained by dissolving or dispersing a chain extender in water as necessary in addition to the aliphatic polyisocyanate compound and the polyol compound, and is polymerized by a known method.

Examples of the chain extender include polyols such as ethylene glycol, 1,4-butanediol, trimethylolpropane, triisopropanolamine, N,N-bis(2-hydroxypropyl)aniline, hydroquinone-bis(β-hydroxyethyl) ether and resorcinolbis(β-hydroxyethyl) ether; polyamines such as ethylenediamine, propylenediamine, hexamethylenediamine, phenylenediamine, tolylenediamine, diphenyldiamine, diaminodiphenylmethane, diaminodiphenylmethane, diaminodicyclohexylmethane, piperazine, isophoronediamine, diethylenetriamine and dipropylenetriamine; hydrazines; and water.

The content of the urethane resin in the resin composition is not particularly limited as long as the urethane resin exhibits versatile adhesiveness to EVA, PVA, or PVB having a high degree of saponification and moist-heat resistant adhesiveness, but is preferably 4% by mass or more and 60% by mass or less where the total mass of the resin composition is 100% by mass. From the above point of view, the content is more preferably 4% by mass or more and 50%

by mass or less, and still more preferably 5% by mass or more and 50% by mass or less. When a polyester-urethane copolymer is used, the amount of the polyisocyanate compound charged at the time of copolymerization is defined as the content of the urethane resin.

When the resin composition contains the acrylic modified polyester resin and the urethane resin, the total content of the acrylic modified polyester resin and the urethane resin in the resin composition is preferably 30% by mass or more and 90% by mass or less, where the total content of all the constituent components of the resin composition is 100% by mass. Owing to the fact that the total content of these resins is 30% by mass or more, adhesiveness to EVA, PVB, or PVA having a wide range of degree of saponification is improved, and good adhesiveness can be maintained even in a high temperature and high humidity environment. Owing to the fact that the total content of these components is 90% by mass or less, the resin composition can contain 10% by mass or more of a compound described later, a melamine compound and/or a compound having a carbodiimide group, and containing these components is preferable because adhesiveness to EVA, PVB or PVA, and flexibility and toughness of the resin layer are improved.

When the acrylic resin and the polyester resin are separately contained instead of the acrylic modified polyester resin, the total content of these components and the urethane resin is preferably 30% by mass or more and 90% by mass or less where the total content of all the constituent components of the resin composition is 100% by mass. Also in this case, when the resin composition contains 10% by mass or more of a compound described later, a melamine compound and/or a compound having a carbodiimide group or the like, the adhesiveness to EVA, PVB or PVA and the flexibility and toughness of the resin layer are improved by containing these components.

When the resin composition contains an acrylic modified polyester resin, the mass ratio of the acrylic modified polyester resin to the urethane resin (the content of the acrylic modified polyester resin [parts by mass]/the content of the urethane resin [parts by mass]) in the resin composition is preferably 50/50 to 90/10. Owing to such a configuration, the glass transition temperature of the resin layer can be easily adjusted to a suitable range, and the change in elastic modulus ($\Delta P$) of the resin layer between 25°C and -20°C can be reduced, so that the change in adhesiveness to a functional material due to temperature can be reduced. When the resin composition contains not the acrylic modified polyester resin but the acrylic resin and the polyester resin separately, the mass ratio of the sum of these components to the urethane resin is preferably in the above range. When a polyester-urethane copolymer is used, the amount of the polyisocyanate compound charged during copolymerization is regarded as the content of the urethane resin, and the amount of the polyester polyol compound charged during copolymerization is regarded as the content of the polyester resin.

As a result of intensive studies by the inventors, in the laminated film of the present invention, owing to the fact that the resin layer contains a "compound or chemical structure having both hydrophobicity and hydrophilicity" together with an acrylic resin, a polyester resin, and a urethane resin (alternatively, an acrylic modified polyester resin and a urethane resin may be used instead, or all of an acrylic skeleton, a polyester skeleton, and a urethane skeleton may be used), separation of the resin layer in the depth direction can be suppressed, and a uniform resin layer can be easily formed.

Examples of the "compound or chemical structure having both hydrophobicity and hydrophilicity" include oxazoline compounds and chemical structures derived from oxazoline compounds. That is, the resin layer in the laminated film of the present invention preferably contains a chemical structure derived from an oxazoline compound or contains an oxazoline compound. When the resin layer contains an oxazoline compound or a chemical structure derived from an oxazoline compound, it is easy to satisfy $0.5 \leq Xs/Xc \leq 2.0$ or satisfy $0.5 \leq Xb/Xc \leq 2.0$. Here, the chemical structure derived from an oxazoline compound refers to a chemical structure (compound) in which a crosslinked structure is formed by the oxazoline compound contained in the resin layer, and for example, refers to a chemical structure (compound) in which an amide ester linkage is formed when a crosslinked structure is formed with a carboxyl group.

The oxazoline compound that can be used in the present invention is not particularly limited as long as it has an oxazoline group as a functional group, but it is preferable to contain an oxazoline group-containing copolymer containing at least one type of constituent unit derived from a monomer containing an oxazoline group. Examples of the monomer containing an oxazoline group include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, and 2-isopropenyl-5-ethyl-2-oxazoline, and one kind or a mixture of two or more kinds thereof can also be used. Among them, 2-isopropenyl-2-oxazoline is industrially easily available and suitable. Incidentally, the chemical structure derived from an oxazoline compound contained in the resin layer of the laminated film of the present invention is preferably one derived from any of the oxazoline compounds described above.

In the oxazoline compound, another monomer to be used to the addition polymerizable oxazoline, namely, a monomer for obtaining the oxazoline group-containing copolymer other than the monomer containing an oxazoline group is not particularly limited as long as it is a monomer copolymerizable with the monomer containing an oxazoline group, but it is preferably a monomer having a hydrophobic skeleton. When the monomer other than the monomer containing an oxazoline group has a hydrophobic skeleton, a hydrophilic oxazoline group is polymerized, so that an oxazoline compound having both hydrophobicity and hydrophilicity can be formed.

As the monomer containing a hydrophobic skeleton, acrylic acid esters or methacrylic acid esters such as methyl acrylate, methyl methacrylate, ethyl acrylate, ethyl methacrylate, butyl acrylate, butyl methacrylate, 2-ethylhexyl acrylate

and 2-ethylhexyl methacrylate, unsaturated carboxylic acids such as acrylic acid, methacrylic acid, itaconic acid and maleic acid, unsaturated nitriles such as acrylonitrile and methacrylonitrile, unsaturated amides such as acrylamide, methacrylamide, N-methylol acrylamide and N-methylol methacrylamide, vinyl esters such as vinyl acetate and vinyl propionate, vinyl ethers such as methyl vinyl ether and ethyl vinyl ether, olefins such as ethylene and propylene, halogen-containing $\alpha,\beta$-unsaturated monomers such as vinyl chloride, vinylidene chloride and vinyl fluoride, and $\alpha,\beta$-unsaturated aromatic monomers such as styrene and $\alpha$-methylstyrene, and the like can be used, and one kind or a mixture of two or more kinds thereof can also be used.

In addition, when the resin layer contains an oxazoline compound or a chemical structure derived from an oxazoline compound, it is easy to adjust $\Delta P$ to 0.2 GPa or more and 2.0 GPa or less, or to adjust the elastic modulus ratio P' to 0.1 or more and 2.3 or less. The oxazoline compound can form a crosslinked structure for strengthening the resin layer while maintaining flexibility, together with each component among the urethane resin, the polyester resin, the acrylic resin, the acrylic modified polyester resin, and the polyester-urethane copolymer. Accordingly, $\Delta P$ and the elastic modulus ratio P' can be adjusted within suitable ranges. In addition, since a part of the oxazoline compound contained in the resin layer remains in the resin layer without forming a crosslinked structure, the oxazoline compound reacts with an acetyl group or a hydroxy group of a functional material to contribute to improvement of adhesiveness.

Preferably, the resin layer of the present invention satisfies $XO/Xs \geq 1.0$, when positive secondary ion normalized intensities of GCIB-TOF-SIMS of the oxazoline compound at the surface layer and the position of 20% of the thickness of the resin layer are denoted by XO and XOs, respectively. The fact that $XO/Xs \geq 1.0$ is satisfied means that the oxazoline compound or a chemical structure derived from the oxazoline compound remain on the surface layer side of the resin layer, and as a result, the water droplet contact angle can be adjusted in a suitable range, and as a result, the affinity with the functional material is increased and the adhesiveness is improved. From the above viewpoint, XO/Xs is more preferably 1.1 or more and 3.0 or less, and still more preferably 1.2 or more and 2.5 or less. When XO/Xs satisfies the above preferable range, it can be expected not only to improve the adhesiveness to a functional material but also to reduce blocking of the film having been wound up into a roll form.

From the viewpoint of easily adjusting $\Delta P$ and the elastic modulus ratio P' to fall within suitable ranges, and from the viewpoint of adjusting the water droplet contact angle to fall within a suitable range, and also from the viewpoint of easily satisfying $XO/Xs \geq 1.0$, the oxazoline compound is contained more preferably in an amount of 30 parts by mass or more and 90 parts by mass or less, still more preferably 30 parts by mass or more and 70 parts by mass or less, and particularly preferably 35 parts by mass or more and 60 parts by mass or less where the total amount of the acrylic resin, the polyester resin, the urethane resin, the acrylic modified polyester resin, and the polyester-urethane copolymer is 100 parts by mass as a resin composition to be used when the resin layer is formed. When the content of the oxazoline compound is within the above range, it can be expected that blocking of the film having been wound up into a roll form can be reduced. When the resin layer contains all of an acrylic skeleton, a polyester skeleton, and a urethane skeleton (when the resin layer satisfies Feature C), it is preferable that the mass ratio of a portion containing these skeletons and a portion containing a chemical structure derived from an oxazoline compound is within the above range for the same reason.

In addition, the resin layer may, as necessary, contain various additives such as a melamine compound and/or a compound having a carbodiimide group to be described later, an easily slipping agent, inorganic particles, organic particles, a surfactant, and a surface treatment agent. For example, the content of the melamine compound is preferably 40 parts by mass or less, and more preferably less than 20% by mass where the total amount of the acrylic resin, the polyester resin, and the urethane resin (or the acrylic modified polyester resin and the urethane resin) as the resin composition in forming the resin layer is 100 parts by mass. When the content of the melamine compound and/or the compound having a carbodiimide group is 40 parts by mass or less, characteristics of the resin layer such as flexibility and toughness can be improved while the adhesiveness of the resin layer to a hydrophilic material is maintained. Furthermore, the melamine compound is preferable because blocking of the film having been wound up into a roll form can be reduced. The melamine compound may exist as a single substance in the resin layer, or may exist as a part of the crosslinked structure. The same applies to a compound having a carbodiimide group described later.

The melamine compound that can be used for the resin layer of the laminated film of the present invention is not particularly limited as long as it has a melamine skeleton, but from the viewpoint of solubility as a coating liquid and planarity of the resin layer, specifically, a compound obtained by subjecting a methylolmelamine derivative obtained by condensation between melamine and formaldehyde to a dehydration condensation reaction with methyl alcohol, ethyl alcohol, isopropyl alcohol or the like as a lower alcohol to etherify the derivative, or the like is preferable.

Examples of a methylolated melamine derivative include monomethylolmelamine, dimethylolmelamine, trimethylolmelamine, tetramethylolmelamine, pentamethylolmelamine, and hexamethylolmelamine.

The compound having a carbodiimide group is not particularly limited as long as it has, for example, at least one carbodiimide structure represented by the following Formula (6) per molecule, but a polycarbodiimide compound having two or more carbodiimide groups in one molecule of the compound is more preferable from the viewpoint of moist-heat resistant adhesiveness and the like. In particular, use of a polymer-type isocyanate compound having a plurality of carbodiimide groups at the ends or side chains of a polymer such as a polyester resin or an acrylic resin is preferable in that

when a resin layer used in the present invention is provided on a film to form a laminated film, not only the hardness enhancement and oligomer deposition suppression property of the resin layer but also adhesiveness to various inks, a hard coat agent, and the like, moist-heat resistant adhesiveness, flexibility, and toughness are enhanced.

-N=C=N- Formula (6)

.

Known techniques can be applied to the production of the compound having a carbodiimide group, and generally, the compound is obtained by polycondensing a diisocyanate compound in the presence of a catalyst. As the diisocyanate compound, which is a starting material of the polycarbodiimide compound, aromatic, aliphatic, alicyclic diisocyanate or the like can be used, and specifically, tolylene diisocyanate, xylene diisocyanate, diphenylmethane diisocyanate, hexamethylene diisocyanate, cyclohexane diisocyanate, isophorone diisocyanate, dicyclohexyl diisocyanate or the like can be used. Furthermore, to improve the solubility in water and dispersibility in water of the polycarbodiimide compound as long as the effects of the present invention are not lost, a surfactant may be added, or a hydrophilic monomer such as a polyalkylene oxide, a quaternary ammonium salt of a dialkylamino alcohol, or a hydroxyalkylsulfonic acid salt may be added for use.

In addition, other compounds, for example, known crosslinking agents such as epoxy compounds and isocyanate compounds, may be optionally used.

The laminated film of the present invention preferably has a laminated structure unit in which 51 or more layers including at least a layer (layer A) a main component of which is a polyester resin (resin A) and a layer (layer B) a main component of which is a thermoplastic resin (resin B) differing from the resin A are laminated. The laminated structure unit as called herein refers to a portion in which layer A and layer B are alternately laminated in a regular arrangement in the thickness direction, and the layers are laminated in a regular arrangement such as A(BA)n (n is a natural number representing the number of repeating units). In addition, the laminated structure unit may include a layer made of a third thermoplastic resin (layer C), and the arrangement thereof is not particularly limited, and examples thereof include a unit in which the layers are laminated in order with a certain regularity, such as C(BA)nC, C(ABC)n, and C(ACBC)n (n is a natural number representing the number of repeating units). In addition, "51 or more layers" means that the total number of layers repeated in the laminated structure unit, for example, layer A and layer B, or layer A, layer B, and layer C, is 51 or more.

To obtain a laminated film having a laminated structure unit of such an aspect, it is preferable to use the film having the laminated structure unit described above as a film for a substrate. Hereinafter, for the purpose of simplifying the description, some description is made by taking an example of a laminated film having a configuration, which is one of preferable aspects of the present invention, in which layer A and layer B are alternately laminated, but the invention should be understood similarly even when three or more thermoplastic resins are used. Hereinafter, the film for a substrate having the laminated structure unit of such an aspect may be referred to as a multilayer film.

For example, use of such a multilayer film for a film for a substrate makes it easy to exhibit a function of selectively reflecting light in a specific wavelength band by interference reflection, a function of reflecting light of specific polarized light, and the like due to the relationship between the difference in refractive index among layers and the layer thickness. As a result, application of a laminated film having such a multilayer film as a substrate to a solar battery back sheet (solar battery rear surface protecting sheet) makes it possible to impart functions such as heat shielding property due to reflection of infrared rays and deterioration preventing function due to reflection of ultraviolet rays to a solar battery. In particular, the enhancement of the heat shielding property of the laminated film reduces the temperature rise of the solar battery due to direct sunlight or reflected light from the ground surface, so that degradation of the solar battery due to heat is inhibited, leading to improvement and maintenance of power generation efficiency.

Examples of other applications to which a laminated film having such a multilayer film as a substrate can be applied are as follows. A laminated film having functions such as heat shielding property due to reflection of infrared rays or deterioration preventing function due to reflection of ultraviolet rays can be made into a laminated glass capable of maintaining high heat shielding performance for a long period of time by sandwiching the laminated film between two sheets of glass. Furthermore, a laminated film having a function of reflecting light with a specific polarization can also be made into a member suitable for a display device that displays images by light with a specific polarization by sandwiching the laminated film between two sheets of glass.

Herein, the fact that resin A and resin B are different means that the resin A and the resin B have different melting points or crystallization temperatures. The "different melting points or crystallization temperatures" means that either the melting points or the crystallization temperatures determined by the measurement method described later are different by 3°C or more. In addition, when one resin has a melting point while the other resin does not have a melting point, or when one resin has a crystallization temperature while the other resin does not have a crystallization temperature, they are also regarded to have different melting points or crystallization temperatures. The combination of the resin A and the resin B is more preferably a combination of resins having different melting points and having different crystallization temperatures.

In the multilayer film used for the laminated film of the present invention, the difference in in-plane average

refractive index between layer A and layer B is preferably 0.03 or more. The difference in in-plane average refractive index is more preferably 0.05 or more, and still more preferably 0.10 or more. When the difference in in-plane average refractive index between layer A and layer B is larger than 0.03, sufficient reflectance is obtained, so that, for example, heat ray cutting performance is improved. The method for adjusting the difference in in-plane average refractive index between the layer A and the layer B within the above range may be a method involving an aspect in which one of the resins A and B is crystalline and the other is amorphous. The crystallinity as used herein means that the enthalpy of fusion is 10 J/g or more in differential scanning calorimetry (DSC). On the other hand, the term "amorphous" similarly means that the enthalpy of fusion is less than 10 J/g. In the case of such a combination of resins, it is possible to easily provide a refractive index difference in the stretching and heat treatment steps in the production of the film.

The combination of the resin A and the resin B constituting the multilayer film used for the laminated film of the present invention is preferably a combination of resins having the same basic backbone. The basic backbone referred to herein means the repeating unit contained in the largest amount the repeating units constituting a resin. For example, when polyethylene terephthalate is used as one of the thermoplastic resins, it is preferable for the other thermoplastic resin also contains an ethylene terephthalate unit as a basic backbone from the viewpoint of easy formation of a highly accurate laminated structure. When the resins A and B are resins containing the same basic backbone, the lamination accuracy is high, and delamination at the lamination interface is less likely to occur.

A preferred combination of the resin A and the resin B of the multilayer film to be used for the laminated film of the present invention may be a combination of resins having a glass transition temperature difference of 20°C or less. When the difference in glass transition temperature between the two resins is more than 20°C, the thickness at the time of forming the multilayer film may be more uneven, leading to poor appearance of a laminated film finally obtained, and problems such as occurrence of overstretching may occur at the time of molding the multilayer film. Of the resins A and B, the glass transition temperature of the crystalline resin is preferably lower than the glass transition temperature of the amorphous resin. In this case, when the multilayer film is stretched at a stretching temperature appropriate for orienting and crystallizing the crystalline resin, the orientation of the amorphous resin can be suppressed as compared to the orientation of the crystalline resin, and a difference in in-plane average refractive index can be easily provided.

In the multilayer film used for the laminated film of the present invention, examples of the dicarboxylic acid unit of the polyester resin used for the resin A, the resin B, and the resin C, which is a main component of the layer C that may be provided as necessary, include constituent units derived from terephthalic acid, isophthalic acid, phthalic acid, naphthalenedicarboxylic acid (1,4-naphthalenedicarboxylic acid, 1,5-naphthalenedicarboxylic acid, 2,6-naphthalenedicarboxylic acid, 2,3-naphthalenedicarboxylic acid), 4,4'-diphenyldicarboxylic acid, 4,4'-diphenyletherdicarboxylic acid, 4,4'-diphenylsulfonedicarboxylic acid, adipic acid, suberic acid, sebacic acid, dimer acid, dodecanedionic acid, cyclohexanedicarboxylic acid, and ester-forming derivatives thereof. These acid components may be used singly or two or more thereof may be used in combination, and they may be partly copolymerized with an oxyacid such as hydroxybenzoic acid.

Examples of the diol unit that can be used for these resins include constituent units derived from ethylene glycol, 1,2-propanediol, 1,3-butanediol, 1,4-butanediol, 1,5-pentadiol, diethylene glycol, polyalkylene glycol, 2,2-bis(4'-β-hydroxyethoxyphenyl)propane, isosorbate, 1,4-cyclohexanedimethanol, spiroglycol, neopentyl glycol, polyethylene glycol, polypropylene glycol, polybutylene glycol, triethylene glycol, tetraethylene glycol, polytetramethyleneether glycol, and ester-forming derivatives thereof.

Examples of the dicarboxylic acid unit constituting these resins preferably include constituent units such as terephthalic acid, 2,6-naphthalenedicarboxylic acid, and isophthalic acid, and examples of the diol unit preferably include constituent units such as ethylene glycol, 1,4-cyclohexanedimethanol, polyalkylene glycol, polyethylene glycol, tetraethylene glycol, and polytetramethylene ether glycol. These diol components may be used singly or two or more thereof may be used in combination.

One example of a suitable combination of the resins A and B satisfying the condition of glass transition temperature described above may be an example in which one of the resins A and B is polyethylene terephthalate or polyethylene naphthalate, and the other is a polyester containing a spiroglycol-derived polyester. The "spiroglycol-derived polyester" is a polyester containing spiroglycol as a diol component, and refers to a copolymer with another ester structural unit, a polyester containing spiroglycol as a single diol component, or a polyester that is a blend of the above-mentioned components with another polyester resin and in which spiroglycol residues preferably occupy half or more of all the diol residues in the polyester resin. The spiroglycol-derived polyester is preferable because it has a small glass transition temperature difference from polyethylene terephthalate or polyethylene naphthalate, and thus is not easily overstretched during molding and is also difficult to delaminate.

From the above point of view, it is more preferable that one of the resins A and B is polyethylene terephthalate or polyethylene naphthalate, and the other is a polyester prepared using spiroglycol and cyclohexanedicarboxylic acid. When a polyester prepared using spiroglycol and cyclohexanedicarboxylic acid is used for one layer, the difference in in-plane refractive index from polyethylene terephthalate or polyethylene naphthalate is large, so that high reflectance is easily obtained. Moreover, the polyester prepared using spiroglycol and cyclohexanedicarboxylic acid has a small glass transition temperature difference from polyethylene terephthalate or polyethylene naphthalate and is superior in adhesiveness, and thus is not easily overstretched during molding and is also resistant to delaminate.

In the multilayer film to be used for the laminated film of the present invention, it is also preferable that one of the resins A and B is polyethylene terephthalate or polyethylene naphthalate, and the other is a cyclohexanedimethanol-derived polyester. The cyclohexanedimethanol-derived polyester is a polyester prepared using cyclohexanedimethanol as a diol component, and refers to a copolymer with another ester structural unit, a polyester prepared using cyclohexanedimethanol as a single diol component, or a polyester in which the above-mentioned components are blended with another polyester and in which cyclohexanedimethanol residues account for half or more in number of all the diol residues. The cyclohexanedimethanol-derived polyester is preferably used because it has a small glass transition temperature difference from polyethylene terephthalate or polyethylene naphthalate, and thus is not easily overstretched during molding and is also resistant to delaminate. More preferably, at least one thermoplastic resin is an ethylene terephthalate polycondensate having a copolymerization amount of cyclohexanedimethanol of 15 mol% or more and 60 mol% or less.

In such an aspect, the film suffers from little change in optical characteristics particularly due to heating or aging, and hardly delaminates between layers while having high reflection performance. Furthermore, an ethylene terephthalate polycondensate having a copolymerization amount of cyclohexanedimethanol of 15 mol% or more and 60 mol% or less adheres very strongly to polyethylene terephthalate. In addition, cyclohexanedimethanol groups of the ethylene terephthalate polycondensate have cis and trans isomers as geometric isomers, and also have chair and boat isomers as conformational isomers. Therefore, the ethylene terephthalate polycondensate is hardly oriented and crystallized even when being subjected to co-stretching with polyethylene terephthalate. For this reason, the resulting film has high reflectance, exhibits further reduced change in optical characteristics due to thermal history, and is less likely to be broken during film formation.

As described above, resins having different melting points or crystallization temperatures usually have different optical properties. Therefore, alternate lamination of such resins makes it easy to reflect light in a specific wavelength band due to the relationship between the difference in refractive index among layers and the layer thickness. In addition, as the number of layers to be laminated increases, a high reflectance can be obtained over a wider band. From this viewpoint, the number of layers of the laminated structure unit is preferably 51, more preferably 201 or more, and still more preferably 401 or more. In such reflection (interference reflection), the wavelength band is wider and the reflectance is higher as the total number of the layer A and the layer B increases, so that a laminated structure unit having high light shielding performance can be obtained. Therefore, although the laminated structure unit has no upper limit on the number of layers, realistically speaking, a practical number of layers is 1001 or less in total. This is because the manufacturing cost increases due to an increase in the size of the manufacturing apparatus, and the handling property is deteriorated due to an increase of the film thickness as the number of layers of the laminated structure unit increases.

It is preferable with the laminated film of the present invention from the viewpoint of enhancing reflection characteristics such as heat shielding property that, on at least one surface thereof, when light having a wavelength in the range of 300 nm to 2500 nm is incident at an incident angle of 10°, there is a wavelength at which the reflectance is 30% or more, more preferably that there is a wavelength at which the reflectance is 50% or more, and still more preferably that there is a wavelength at which the reflectance is 80% or more. Furthermore, from the same viewpoint, on at least one surface, when light having a wavelength in the range of 300 nm to 2500 nm is incident at an incident angle of 10°, the laminated film of the present invention preferably has at least one reflection band in which a reflectance of 30% or more continues over a wavelength width of 20 nm or more, more preferably a wavelength width of 100 nm or more, and still more preferably a wavelength width of 300 nm or more.

The reflectance at each wavelength can be measured as a relative reflectance based on a white plate of aluminum oxide, and details thereof will be described later. The incident angle refers to an angle formed with a normal line to the film surface. "On at least one surface" means that it is sufficient that the requirement is satisfied when light is applied to at least one surface and the reflectance is measured, and preferably that the requirement is satisfied when light is applied to the surface on the resin layer side and the reflectance is measured. Hereinafter, "on at least one surface" in the measurement of the optical characteristics shall be interpreted in the same manner.

Such characteristics can be realized by using the multilayer film as a film for a substrate and increasing the difference in-plane average refractive index between the layer A and the layer B. Therefore, in the case where the multilayer film is made into a biaxially stretched film, the multilayer film is preferably a multilayer polyester film in which a layer containing a crystalline polyester resin as a main component and a layer containing a low refractive index copolymerized polyester which maintains amorphous properties during stretching or is melted in a heat treatment step as a main component are alternately laminated.

It is preferable with the laminated film of the present invention that, on at least one surface thereof, when light is incident at an incident angle of 10°, the average reflectance in a band with a wavelength of 400 nm to 700 nm is 15% or less and the average reflectance in a band with a wavelength of 850 nm to 1200 nm is 70% or more. By adopting such an aspect, reflection in the visible region can be suppressed, coloring and glittering can be reduced, and infrared rays can be reflected. Therefore, such a laminated film is superior in heat shielding property. For example, by sandwiching such a laminated film between two sheets of glass, a laminated glass capable of maintaining high heat shielding performance for a

long period of time can be obtained.

The laminated film having an average reflectance in a band with a wavelength of 850 to 1200 nm of 70% or more can be obtained, for example, by using a multilayer film as the film for a substrate of the laminated film, and increasing the total number of the layer A and the layer B or/and increasing the difference in in-plane average refractive index between the layer A and the layer B. The total number of layers depends on the difference in in-plane average refractive index between the layer A and the layer B (or resins A and B which are main components of these layers), but the total number of the layer A and the layer B is preferably 201 or more. Setting the total number of the layer A and the layer B to 201 or more makes it easy to adjust the average reflectance in a band with a wavelength of 850 to 1200 nm to 70% or more. When the average reflectance in the band with a wavelength of 850 to 1200 nm is adjusted to 80% or more, it is preferable to set the total number of the layer A and the layer B to 401 or more.

To obtain such a laminated film, for over half of the layers constituting the multilayer film (laminated structure unit) to be used as the substrate of the laminated film, the sum of optical thicknesses of adjacent layers is preferably 400 to 700 nm. The optical thickness referred to herein is the product of the layer thickness of each layer and the refractive index of the resin constituting the layer, and the sum of the optical thicknesses of adjacent layers is a factor that determines the wavelength at which interference reflection occurs in the laminated film. Interference reflection due to a laminated structure unit in which the sum of optical thicknesses of adjacent layers is 400 to 700 nm usually occurs in a wavelength range of about 800 to 1400 nm, so that it is easy to adjust an average reflectance in a band with a wavelength of 850 to 1200 nm to 70% or more. In addition, the magnitude of the reflectance increases as the number of layers or the difference in in-plane average refractive index between adjacent layers increases. In a multilayer film having a laminated structure unit in which for over half of the layers, the sum of optical thicknesses of adjacent layers is 400 to 700 nm, it is easy to efficiently enhance the average reflectance in the band with a wavelength of 850 to 1200 nm.

For example, when polyethylene terephthalate having a refractive index of 1.66 and polyethylene terephthalate having a refractive index of 1.55 obtained by copolymerizing spiroglycol and cyclohexanedicarboxylic acid are used as the resins A and B, the number of layers in which the sum of optical thicknesses of adjacent layers is 400 to 700 nm is about 201 or more in order to adjust the average reflectance in the band with a wavelength of 850 to 1200 nm to 70% or more. As the difference in in-plane average refractive index between the resins A and B increases, the number of layers required for adjusting the maximum value of the reflectance in the zone with a wavelength of 850 to 1200 nm to 70% or more decreases, and when the difference in in-plane average refractive index is 0.3 or more, a sufficient reflectance can be imparted even when the number of layers is about 51. When polyethylene terephthalate having a refractive index of 1.66 and polyethylene terephthalate having a refractive index of 1.55 obtained by copolymerizing spiroglycol and cyclohexanedicarboxylic acid are used as the thermoplastic resins, the range of the layer thickness necessary for adjusting the sum of the optical thicknesses of adjacent layers to 400 to 700 nm is about 120 to 220 nm.

In another example of the laminated film having an average reflectance in a band with a wavelength of 850 to 1200 nm of 70% or more, the optical thicknesses of adjacent layer A and layer B simultaneously satisfy the following Formulas (7) and (8).

[Math. 1]

$$\lambda = 2(n_\alpha d_\alpha + n_\beta d_\beta) \quad (7)$$

[Math. 2]

$$n_\alpha d_\alpha = n_\beta d_\beta \quad (8)$$

Here, $\lambda$ is the reflection wavelength; $n_\alpha$ is the in-plane refractive index of the layer A; $d_\alpha$ is the thickness of the layer A; $n_\beta$ is the in-plane refractive index of the layer B, and $d_\beta$ is the thickness of the layer B. Owing to having a layer thickness distribution that simultaneously satisfies the expressions (7) and (8), even-order reflection can be eliminated. Therefore, the average reflectance in the wavelength range of 850 nm to 1200 nm can be increased and simultaneously the average reflectance in the wavelength range of 400 to 700 nm, which is the visible light region, can be decreased, so that a transparent film having high heat ray cutting performance can be obtained. Since the refractive index of a film generally after molding a thermoplastic resin and stretching it is about 1.4 to 1.9, a film in which even-order reflection is suppressed can be obtained by adjusting the ratio of the thicknesses of adjacent the layer A and the layer B (thickness of layer A/thickness of layer B) to 0.7 or more and 1.4 or less. Therefore, the ratio of the thicknesses of the adjacent layer A and layer B (thickness of layer A/thickness of layer B) is preferably 0.7 or more and 1.4 or less. The ratio is more preferably 0.8 or more and 1.2 or less.

One aspect of the multilayer film to be used for the laminated film of the present invention is an aspect in which the refractive index of at least one surface of the laminated polyester film is 1.68 or more and 1.80 or less. When the refractive index is lower than 1.68, it may be difficult to have a reflection band in which the reflectance is 30% or more over 20 nm or

more in the wavelength range of 300 nm to 2500 nm. When the refractive index is higher than 1.80, the difference in chemical structure is large, so that the lamination property between the resin A and the resin B is deteriorated, and cloudiness of the multilayer film or peeling at the interface between the layer A and the layer B may be remarkable.

Examples of the method for adjusting the refractive index of at least one surface of the multilayer film to 1.68 or more and 1.80 or less include a method with an aspect in which the main dicarboxylic acid unit of the resin A is a naphthalene dicarboxylic acid unit. By adopting such an aspect, a difference in refractive index between the layer A and the layer B can be provided, and a laminated polyester film further superior in reflection performance can be easily obtained. To increase the difference in refractive index between the layer A and the layer B, the resin B is preferably an amorphous resin. To incorporate naphthalene dicarboxylic acid as a dicarboxylic acid constituent component to the resin A of the laminated polyester film of the present invention, a method involving containing naphthalene dicarboxylic acid as a dicarboxylic acid constituent component of a raw material polyester resin to constitute the resin A can be used.

It is preferable with the laminated film of the present invention that, on at least one surface thereof, the average transmittance of visible light normally incident is 50% or more and 100% or less, and when the average reflectances (%) of a P-polarized wave having a wavelength of 400 nm to 700 nm attained when P-polarized wave light is incident at angles of 20°, 40° and 70° with respect to a normal line to a film surface are denoted by R20, R40 and R70, a relationship of R20 ≤ R40 < R70 is satisfied.

Herein, "be normal" means an angle of 0° with respect to the film surface itself or the tangential plane of the film surface. Owing to the fact that the average transmittance of normally incident visible light having a wavelength of 400 to 700 nm is 50% or more and 100% or less, the laminated film has transparency like transparent glass or transparent resin film. Therefore, when the laminated film of such an aspect is made into a laminated glass in which the laminated film is sandwiched between two sheets of glass, and the background is observed from a direction perpendicular to the laminated glass, good visibility of the background is obtained.

From the above viewpoint, the transmittance is preferably 70% or more, more preferably 80% or more, and still more preferably 90% or more. In the case where the transmittance is 90% or more, when the background is observed from a direction perpendicular to the laminated glass, the background can be visually recognized without feeling the presence of the laminated glass. The upper limit of the transmittance is preferably 99% from the viewpoint of feasibility.

Although detailed measurement conditions will be described in Examples, the transmittance of light normally incident on the laminated film can be measured by measuring the transmittance of light having a wavelength of 400 to 700 nm at an incident angle $\theta$ of 0° in increments of 1 nm with a spectrophotometer and calculating an average value of the measurements.

In addition, an aspect in which when average reflectances (%) of a P-polarized wave having a wavelength of 400 nm to 700 nm attained when P-polarized wave light is incident at angles of 20°, 40° and 70° with respect to a normal line to a film surface are denoted by R20, R40 and R70, a relationship of R20 ≤ R40 < R70 is satisfied is an aspect in which the laminated film does not have an angle corresponding to the Brewster's angle. In the case of a general transparent substrate such as transparent glass or a plastic film, as the incident angle is gradually increased from 20° with respect to the normal line to one surface of the transparent substrate, the reflectance of the P-polarized wave, which is one of polarized light, decreases, and the reflectance reaches 0% at an angle called the Brewster's angle. Therefore, it is difficult for a general transparent substrate to transmit the front direction and reflect the P-polarized wave in the oblique direction.

In the case where a laminated film satisfies, on at least one surface thereof, a relationship of R20 ≤ R40 < R70 when the reflectances (%) of a P-polarized wave attained when P-polarized wave light is incident at angles of 20°, 40° and 70° with respect to a normal line to a film surface are denoted by R20, R40 and R70, the laminated film is suitable for a display device that displays images by P-polarized light applied from the oblique direction. From the viewpoint of improving an image display property, R70 is preferably 30% or more, more preferably 50% or more, and as R70 increases, the display property of a projected image when a P-polarized wave image is projected on a surface of a projected image display member is improved. In addition, the upper limit of R70 is not particularly limited, but is 99% from the viewpoint of feasibility.

The average reflectance (%) of a P-polarized wave can be measured by measuring the reflectance of a P-polarized wave in a wavelength range of 400 to 700 nm at each incident angle $\theta$ of 20°, 40°, and 70° in increments of 1 nm using a spectrophotometer and calculating an average value of the measurements although detailed measurement conditions will be described in Examples.

The following description is made in detail as one example of a method in which a laminated polyester film is made to have a transmittance of visible light normally incident on the film surface adjusted to 50% or more and 100% or less, and where reflectances (%) of a P-polarized wave attained when the P-polarized wave is incident at angles of 20°, 40° and 70° with respect to a normal line to the film surface are denoted by R20, R40 and R70, a relationship of R20 ≤ R40 < R70 is satisfied, and R70 is adjusted to 10% or more.

The average transmittance of visible light normally incident on the laminated polyester film can be reduced by reducing the difference in refractive index in the direction parallel to the film surface (in-plane direction) between the two thermoplastic resin layers. For example, as long as the number of layers of the laminated polyester film is within the range described above, it becomes easy to adjust the transmittance to 50% or more when the difference in refractive index in the

direction parallel to the film surface is 0.06 or less, to 70% or more when the difference in refractive index is 0.04 or less, and to 80% or more when the difference in refractive index is 0.02 or less. The "difference in refractive index in the direction parallel to a film surface" refers to an absolute value of a difference in in-plane refractive index between adjacent thermoplastic resin layers.

To obtain a laminated polyester film satisfying the relationship of R20 ≤ R40 < R70, a method involving adjusting the difference in refractive index in the direction perpendicular to the film surface between the two thermoplastic resin layers and the number of layers may be used. At this time, as the difference in refractive index in the direction perpendicular to the film surface is increased, and as the number of layers is increased, R70 can be increased. For example, in the case where the number of layers reaches 801, if the difference in refractive index in the direction perpendicular to the film surface is 0.08 or more, it is easy to adjust the reflectance to 30% or more, and if the difference in refractive index is 0.12 or more, it is easy to adjust the reflectance to 50% or more. As a result, where the reflectances (%) of the P-polarized wave attained when the P-polarized wave is incident at angles of 20°, 40°, and 70° with respect to a normal line to the laminated polyester film are denoted by R20, R40, and R70, the relationship of R20 ≤ R40 < R70 can be satisfied. Even if the difference in refractive index does not reach the above level, the reflectance can be increased to reach the above level by further increasing the number of layers. Hereinafter, the refractive index in the direction perpendicular to a film surface may be referred to as a perpendicular refractive index.

Examples of the method for adjusting the reflection wavelength of the laminated film to a wavelength range of 400 to 700 nm include adjusting the difference in perpendicular refractive index between two thermoplastic resin layers, the number of laminated layers, the layer thickness distribution, and film formation conditions (for example, the draw ratio, the stretching speed, the stretching temperature, the heat treatment temperature, and the heat treatment time). Regarding the layer thickness distribution, it is preferable that the optical thicknesses of the adjacent layer A and layer B satisfy Formula (7). The crystalline thermoplastic resin in the layer A and the amorphous thermoplastic resin in the layer B are both preferably polyester.

[Math. 3]

$$\lambda = 2(n_\alpha d_\alpha + n_\beta d_\beta) \qquad (7)$$

The layer thickness distribution of the multilayer film to be used for the laminated film of the present invention is preferably a constant layer thickness distribution from the surface of the laminated polyester film on one side toward the surface on the opposite side, a layer thickness distribution such that the layer thickness monotonously increases or decreases from the surface of the laminated polyester film on one side toward the surface on the opposite side, a layer thickness distribution such that the layer thickness increases from the surface of the laminated polyester film on one side toward the film center and then decreases, a layer thickness distribution such that the layer thickness decreases from the surface of the laminated polyester film on one side toward the film center and then increases, and a combination of these distributions. Regarding the way of change in layer thickness distribution, it is preferable that the layer thickness changes continuously such as linearly, geometrically, or in a difference sequence manner, or that the film consists of groups of layers, each containing 10 to 50 layers that have substantially the same layer thickness, that differ stepwise in layer thickness.

On both surface layers of the multilayer film to be used for the laminated film of the present invention, a layer having a thickness of 1% or more of the entire thickness of the multilayer film may be preferably provided as a protective layer, and the thickness of each protective layer is preferably 4% or more of the entire thickness of the multilayer film. An increase in thickness of the protective layer leads to suppression of flow marks during film formation, improvement of the accuracy of the actual layer thickness of each layer with respect to design, suppression of deformation of thin film layers in the multilayer film during and after a lamination step with another film or a molded body, pressing resistance, and the like. The upper limit of the thickness of the protective layer is 20% from the viewpoint of securing a laminated structure unit necessary for exhibiting interference reflection while suppressing an increase in the thickness of the multilayer film. The thickness of the multilayer film is not particularly limited, but for example, it is preferably 20 μm to 300 μm. When the thickness is 20 μm or more, the rigidity of the multilayer film becomes high, and handleability can be secured. When the thickness is 300 μm or less, the rigidity of the multilayer film does not become excessively high, and moldability is improved.

In one example of the laminated polyester film preferably used in the present invention, where a direction parallel to a film surface and having the largest average rate of change in thermal shrinkage measured by thermomechanical analysis in a range of 100°C to 150°C is defined as an X direction, the average rate of change in thermal shrinkage in the X direction is preferably 0.01%/°C or more and 0.1%/°C or less. The term "thermomechanical analysis" as used herein refers to a method of measuring deformation of a substance as a function of temperature by applying a non-vibrational load to the substance while changing the temperature of the substance in accordance with an adjusted program, and is measured with a commercially available thermomechanical analyzer. The thermal shrinkage is defined by Equation (9).

The average rate of change in thermal shrinkage referred to herein is a parameter determined by dividing a

difference in thermal shrinkage between 100°C and 150°C by a temperature difference. Owing to designing a laminated polyester film to such an aspect, when the laminated polyester film is made into a laminated glass in which the laminated polyester film is sandwiched between two intermediate layers and two sheets of glass, wrinkles and peeling can be suppressed and a laminated glass having a good appearance can be obtained. More preferably, the average rate of change in thermal shrinkage is 0.01% or more and less than 0.05%. It is also preferable that where a direction orthogonal to the X direction is defined to be a Y direction, an average rate of change in thermal shrinkage measured by thermomechanical analysis in a range of 100°C to 150°C in both the X direction and the Y direction is 0.01%/°C or more and 0.1%/°C or less. In this case, since thermal shrinkage changes isotropically, it is possible to appropriately follow the change in the thermal shrinkage of the intermediate layers, and the occurrence of wrinkles and peeling can be almost inhibited.

To design a laminated film such that where a direction parallel to a film surface and having the largest average rate of change in thermal shrinkage measured by thermomechanical analysis in a range of 100°C to 150°C is defined as an X direction, the average rate of change in thermal shrinkage in the X direction is 0.01%/°C or more and 0.1%/°C or less, it is preferable to strengthen the orientation in the film longitudinal direction by adjusting the longitudinal draw ratio and the longitudinal stretching temperature in the production of the laminated film. For example, when a multilayer film is used as a film for a substrate of a laminated film, a desired multilayer film is easily obtained by adjusting the longitudinal stretching temperature to 90°C or less or the longitudinal draw ratio to 3.5 or more. Similarly, it is also preferable to strengthen the orientation in the direction orthogonal to the longitudinal direction by the transverse stretching temperature and the transverse draw ratio. For example, when a multilayer film is used as the film for a substrate of a laminated film, a desired multilayer film is easily obtained by adjusting the transverse stretching temperature to 110°C or less or the transverse draw ratio to 3.8 or more. In addition, to suppress the difference in thermal shrinkage behavior between the longitudinal direction of the multilayer film and the direction orthogonal thereto, it is desirable to adjust the longitudinal stretching conditions and the transverse stretching conditions. Specifically, by adjusting the difference between the longitudinal draw ratio and the transverse draw ratio to 0.3 or less, or by adjusting the temperature difference between the longitudinal stretching temperature and the transverse stretching temperature to 20°C or more, the thermal shrinkage behavior is easily made isotropic. These methods may be used in appropriate combination, and by use of the multilayer film thus obtained as a film for a substrate, a laminated film having an average rate of change in thermal shrinkage in the X direction of 0.01%/°C or more and 0.1%/°C or less can be obtained.

When there is a difference in melting point between the resin A and the resin B, the heat treatment temperature after stretching is preferably set to a temperature between the melting points of the resin A and the resin B. In this case, while the resin having a relatively high melting point maintains a high orientation state, the orientation of the other resin is relaxed, so that a difference in refractive index between these resins can be easily provided, and it is also possible to impart a higher thermal shrinkage behavior to the thermoplastic resin maintaining the orientation. When the resin A is a crystalline polyester and the resin B is a polyester resin composed of an amorphous polyester and a crystalline polyester, the heat treatment temperature is preferably equal to or lower than the crystalline polyesters contained in the resin A and the resin B. In this case, since the orientation of the crystalline polyester contained in the resin B is also maintained in addition to the orientation of the resin A, a higher thermal shrinkage behavior can be imparted.

In addition, since the relaxation treatment described above is performed to suppress the thermal shrinkage behavior, it is also preferable not to perform the relaxation treatment. A preferable degree of the relaxation treatment is 0% or more and 5% or less in terms of the percentage of the relaxation treatment based on the film width before the relaxation treatment (the fact that the percentage of the relaxation treatment is 0% means that the relaxation treatment itself is not performed). Depending on the types of the resins A and B to be laminated, for example, if the resins are polyethylene terephthalate and an amorphous polyester that is completely melted in the heat treatment step, it is possible to obtain a multilayer film having the best thermal shrinkage behavior when the percentage of the relaxation treatment to the film width before the relaxation treatment is in the range of about 0% to 1%.

Herein, the longitudinal direction refers to a direction in which a sheet or a film travels (in the case of a film roll, a winding direction of the film), and the width direction refers to a direction orthogonal to the longitudinal direction in a film plane. In general, the thermal shrinkage is present as residual stress of stress with respect to stretching, and the thermal shrinkage is increased. Therefore, either the longitudinal direction or the width direction is the X direction, and the other is the Y direction.

In the laminated film of the present invention, a minute endothermic peak determined by differential scanning calorimetry is preferably present at 170°C or higher and 210°C or lower. The minute endothermic peak is an endothermic peak corresponding to a thermal history corresponding to the heat treatment temperature at the time of transverse stretching described later, and the thermal shrinkage of the laminated film varies depending on the temperature of the endothermic peak. By adjusting the minute endothermic peak to 170°C or higher and 210°C or lower, the shrinkage of the laminated film approximates the shrinkage of EVA, PVB, or PVA, and thus it is possible to suppress the occurrence of wrinkles or the like in a thermal processing step such as laminated glass fabrication. The minute endothermic peak is usually observed on the lower temperature side than the melting point and in the vicinity of the melting point, and is observed in the first run of differential scanning calorimetry. Since no minute endothermic peak is observed in the second

run in which the temperature is once raised to the melting point or higher and the thermal history is thereby erased, the position of the minute endothermic peak can be confirmed by comparing peaks of the two runs. A method of measuring the minute endothermic peak will be described later.

Hereinafter, a preferred method for producing a laminated film will be described using, as an example, a laminated film in which, a multilayer film using polyethylene terephthalate as the resin A constituting the layer A and using a copolymer of polyethylene terephthalate (polyethylene terephthalate in which 20 to 40 mol% of cyclohexanedimethanol component is copolymerized) as the resin B constituting the layer B is used as a film for a substrate. Of course, the laminated film of the present invention should not be construed as being limited to such an example. In addition, the laminated structure unit of the multilayer film can be easily realized by a method similar to that described in paragraphs [0053] to [0063] of Japanese Patent Laid-open Publication No. 2007-307893.

Each resin is prepared in the form of pellets. The pellets are dried in hot air or under vacuum as necessary, and then fed to separate extruders. The resins melted in the extruder by heating at 280 to 300°C are made uniform as to the extrusion amount by a gear pump or the like, and are freed of any foreign matters or denatured resin through a filter or the like. These resins are molded into a desired shape by a die and then discharged. Then, a multilayer laminated sheet discharged from the die is extruded onto a cooling body such as a casting drum, and cooled and solidified into a cast film. In this process, it is preferable to bring the sheet into close contact with the cooling body such as a casting drum by an electrostatic force using a wire-like, tape-like, needle-like, or knife-like electrode, and to rapidly cool and solidify the sheet. It is also preferable to employ a method of bringing the sheet into close contact with the cooling body such as a casting drum by blowing air from a slit-like, spot-like, or planar device, and rapidly cooling and solidifying the sheet, or bringing the sheet into close contact with the cooling body using a nip roll, and rapidly cooling and solidifying the sheet.

At this time, the resin A and the resin B are melt-kneaded by separate extruders and fed to a multilayer lamination device through different flow paths. Examples of usable multilayer laminating apparatuses include a multi-manifold die, a feed block, and a static mixer. In particular, in order to efficiently obtain the configuration of the present invention, a feed block having 51 to 1001 fine slits is preferably used. The use of this type of feed block avoids an extreme increase in size of the apparatus, allows less generation of foreign matters due to heat degradation, and enables highly precise lamination when the number of layers to be laminated is 51 to 1001. Moreover, the precision of lamination in the width direction is also significantly improved as compared with conventional techniques. Further, since such a feed block is capable of adjusting the thickness of each layer by the shape (length and width) of a slit, an arbitrary layer thickness can be easily achieved. The molten multilayer laminate formed to have a desired layer structure as described above is led to a die, and a cast film is obtained as described above.

The cast film thus obtained is preferably biaxially stretched. Herein, "biaxial stretching" refers to stretching in the longitudinal direction and the width direction. Stretching may be performed sequentially in two directions or alternatively may be performed simultaneously in two directions. Further, the film may be re-stretched in the longitudinal direction and/or the width direction.

First, a case of sequential biaxial stretching will be described. In the case of sequential biaxial stretching, usually, stretching in the longitudinal direction (longitudinal stretching) is followed by stretching in the width direction (transverse stretching). Herein, the stretching in the longitudinal direction refers to stretching for imparting molecular orientation in the longitudinal direction to the film, and is usually performed utilizing a circumferential speed difference of rolls. This stretching may be performed in one step, or may be performed in multiple steps using a plurality of roll pairs. Although the draw ratio varies depending on the type of the resin, it is usually preferably 2 to 15, and when polyethylene terephthalate is used as the resin A, the draw ratio is particularly preferably 2 to 7. The stretching temperature is preferably (the glass transition temperature of the resin that constitutes the film) to (the glass transition temperature + 100°C).

A resin layer is formed on the uniaxially stretched film thus obtained by applying a surface treatment such as a corona treatment, a flame treatment, or a plasma treatment to the uniaxially stretched film as necessary, and then performing a step of applying a resin composition. Details of the method for forming the resin layer will be described later.

Subsequently, the stretching in the width direction refers to stretching for imparting orientation in the width direction to the film, and usually, a uniaxially stretched film obtained via the longitudinal stretching is conveyed by a tenter while both end portions in the width direction are held with a plurality of clips, and the film is stretched in the width direction by widening the interval between the opposing clips. Although the draw ratio varies depending on the type of the resin, it is usually preferably 2 to 15, and when polyethylene terephthalate is used as the resin A, the draw ratio is particularly preferably 2 to 7. In particular, in the laminated film of the present invention, the transverse draw ratio is preferably 4 or more. Increasing the transverse draw ratio is effective for increasing the uniformity of the reflection bands and the uniformity of the average reflectance. The stretching temperature is preferably (the greatest glass transition temperature of the resin that constitutes the film) to (the greatest glass transition temperature + 120°C).

The film biaxially stretched as described above is preferably subjected to a heat treatment for imparting planarity and dimensional stability in a tenter at a temperature equal to or higher than the stretching temperature and equal to or lower than the melting point of the thermoplastic resin A. The heat treatment improves the dimensional stability of the film. After being heat-treated in this manner, the film is gradually cooled uniformly, and then cooled to room temperature and

wound up. In addition, a relaxation treatment or the like may be combined as necessary during the gradual cooling from the heat treatment.

Next, the case of simultaneous biaxial stretching will be described. In the case of simultaneous biaxial stretching, the obtained cast film is subjected to a surface treatment such as a corona treatment, a flame treatment, or a plasma treatment as necessary, and then a resin layer is formed by in-line coating.

Then, the cast film is led to a simultaneous biaxial tenter, conveyed with both end portions in the width direction of the film being held with clips, and stretched in the longitudinal direction and the width direction simultaneously and/or in stages. Examples of the type of a tenter that can be used as a simultaneous biaxial stretching machine include a pantograph type, a screw type, a drive motor type, and a linear motor type. A drive motor type or a linear motor type is preferable because the machines of these types are capable of changing the draw ratio arbitrarily and capable of performing the relaxation treatment at any place. Although the draw ratio varies depending on the type of the resin, it is usually preferably 6 to 50 in area ratio. When polyethylene terephthalate is used as the thermoplastic resin A, the draw ratio is particularly preferably 8 to 30 in area ratio. In particular, in the case of simultaneous biaxial stretching, it is preferable to make the draw ratios in the longitudinal direction and the width direction the same and to make the stretching speeds in the longitudinal direction and the width direction substantially equal in order to reduce the in-plane orientation difference. The stretching temperature is preferably (the greatest glass transition temperature of the resin that constitutes the film) to (the greatest glass transition temperature + 120°C).

The film biaxially stretched as described above is preferably subsequently subjected to a heat treatment for imparting planarity and dimensional stability in the tenter at a temperature equal to or higher than the stretching temperature and equal to or lower than the melting point. In the heat treatment, it is preferable to perform a relaxation treatment in the longitudinal direction instantaneously immediately before and/or immediately after the film enters the heat treatment zone in order to reduce the distribution of the main orientation axis in the width direction. After being heat-treated in this manner, the film is gradually cooled uniformly, and then cooled to room temperature and wound up. In addition, a relaxation treatment in the longitudinal direction and/or the width direction may be performed as necessary during the gradual cooling from the heat treatment. Preferably, a relaxation treatment of 1 to 5% may be instantaneously performed in the longitudinal direction immediately before and/or immediately after the film enters the heat treatment zone.

As a method of forming a resin layer on the multilayer film thus obtained, a method of applying a resin composition to at least one surface of the multilayer film to form a resin layer can be used. In this method, the resin composition contains a urethane resin and an acrylic modified polyester resin (alternatively, an acrylic resin and a polyester resin). More preferably, the resin composition contains an oxazoline compound. When such a resin composition is applied onto a thermoplastic resin film, the resin composition may contain a solvent. That is, resin components may be dissolved or dispersed in a solvent to form a coating liquid, which may be applied to the multilayer film. After the application, the solvent is dried and heated to obtain a laminated film on which a resin layer is laminated. In the present invention, it is preferable to use an aqueous solvent as the solvent. This is because, by using the aqueous solvent, rapid evaporation of the solvent in the heating step can be suppressed, and not only a uniform resin layer can be formed, but also it is superior in terms of environmental impact.

Here, the aqueous solvent refers to water, or a mixture of water and a water-soluble organic solvent such as an alcohol such as methanol, ethanol, isopropyl alcohol or butanol, a ketone such as acetone or methyl ethyl ketone, or a glycol such as ethylene glycol, diethylene glycol or propylene glycol in an arbitrary ratio.

As a method for applying the resin composition to the multilayer film, either an in-line coating method or an off-coating method can be used, but the in-line coating method is preferable. The in-line coating method is a method of performing application in a process of the production of a film. Specifically, it refers to a method in which a resin composition is applied at any stage from melt extrusion of a thermoplastic resin to winding up, and usually, the resin composition is applied to any film among a non-stretched (unoriented) polyester film in a substantially amorphous state, which is obtained by melt extrusion and quenching thereafter (film A), an uniaxially stretched (uniaxially oriented) polyester film stretched in a longitudinal direction thereafter (film B), or a biaxially stretched (biaxially oriented) polyester film before heat treatment, which has been further stretched in a width direction (film C).

In the present invention, it is preferable to adopt a method of applying a resin composition to either the film A or the film B which is a polyester film before completion of crystal orientation, evaporating a solvent, and then stretching the polyester film uniaxially or biaxially, and heating the film to complete the crystal orientation of the polyester film and provide the resin layer. This method has a merit in terms of production cost because the production of a film for a substrate can be performed simultaneously with the application of the resin composition, drying of a solvent, and heating (namely, the formation of the resin layer). In addition, it is easy to further reduce the thickness of the resin layer since stretching is performed after application.

Among these, a method of applying the resin composition to a film (film B) which has been uniaxially stretched in the longitudinal direction, drying a solvent, and then stretching the film in the width direction, and heating the film is excellent. This is because the number of stretching steps after the application is smaller by one time as compared with a method of applying the resin composition to an unstretched film and then performing biaxial stretching, thus defects and

cracks in the resin layer due to stretching hardly occurs, and a resin layer superior in transparency and smoothness can be formed.

On the other hand, an off-line coating method is a method in which a resin composition is applied to a film after the film A is uniaxially or biaxially stretched and subjected to a heat treatment to complete the crystal orientation of the polyester film or to the film A in a step different from the film production step. In the present invention, the resin layer is preferably provided by an in-line coating method because of the above-mentioned various advantages.

The best method for forming a resin layer in the present invention is a method of applying a resin composition using an aqueous solvent onto a polyester film by an in-line coating method, and heating and drying the aqueous solvent to form the resin layer.

In the case of preparing a resin composition for forming a resin layer, it is preferable to use an aqueous solvent as the solvent. The resin composition can be prepared by mixing an acrylic modified polyester resin (an acrylic resin and a polyester resin), which is water-dispersed or water-soluble as necessary, with a urethane resin, an oxazoline compound and/or a melamine compound, and an aqueous solvent in an arbitrary order at a desired weight ratio, and then stirring the mixture. Next, if necessary, various additives such as an easily slipping agent, inorganic particles, organic particles, a surfactant, an antioxidant, and a thermal initiator may be mixed and stirred in any order to an extent that the characteristics of the resin layer formed from the resin composition are not deteriorated. The mixing and stirring method can be performed by shaking a container by hand, using a magnetic stirrer or a stirring blade, or ultrasonic irradiation, vibration dispersion or the like.

Here, the method for applying the resin composition to the laminated film may use any known application method, for example, a bar coating method, a reverse coating method, a gravure coating method, a die coating method, a blade coating method, or the like. From the viewpoint of an appropriate coating thickness and viscosity, a bar coating method and a gravure coating method are preferable.

The thickness of the resin layer of the present invention is not particularly limited, but is preferably 20 to 500 nm. Setting the thickness of the resin layer to 20 nm or more makes it easy to provide a uniform resin layer on the film for a substrate. Setting the thickness of the resin layer to 500 nm or less makes it possible to control the occurrence of unevenness and streaks at the time of applying the resin layer and to maintain the quality of the laminated film without increasing the manufacturing cost.

The thickness of the resin layer can be measured using sectional images observed by a transmission electron microscope (TEM), and details thereof will be described later. In addition, the method for adjusting the thickness of the resin layer in the laminated film of the present invention is not particularly limited, and can be appropriately selected from known methods, and examples thereof include a method of adjusting the concentration of the solid content in the resin composition.

In general, a solar battery is fabricated by bonding a transparent substrate such as glass and a resin sheet called a back sheet (rear surface protecting sheet) to a power generating element sealed with a transparent sealant, and the laminated film of the present invention is suitably used for a solar battery module having a configuration in which the sealant is directly laminated. Furthermore, the solar battery is suitably used for a solar battery module having two sealants (sealants 1 and 2), and including the sealant 1, a solar battery cell, the sealant 2, and the laminated film in this order.

A solar battery converts light energy of sunlight taken thereinto through a transparent substrate into electric energy by a power generating element. The electric energy obtained is extracted by a lead wire connected to the power generating element and used for various electric devices. The enhancement of the heat shielding property of the laminated polyester film reduces the temperature rise of the solar battery due to direct sunlight or reflected light from the ground surface, so that degradation of the solar battery due to heat is inhibited, leading to improvement of power generation efficiency.

The laminated film of the present invention includes an intermediate layer and glass, and is suitably used for a glass component in which the laminated film and the intermediate layer are adjacent to each other. Examples thereof include a glass laminate in which the laminated film of the present invention is bonded to one surface of a piece of glass using an intermediate layer, and a laminated glass in which the laminated film is inserted between two pieces of glass and two intermediate layers. Furthermore, it is suitably used for a glass component (laminated glass) having two pieces of glass (glass 1, 2) and two intermediate layers (intermediate layers 1, 2), and including the glass 1, the intermediate layer 1, the laminated film, the intermediate layer 2, and the glass 2 in this order.

The glass to be used in the glass component of the present invention is not particularly limited, and a commonly used transparent sheet glass or the like can be used. Examples thereof include clear glass, float sheet glass, polished sheet glass, mold sheet glass, meshed sheet glass, wired sheet glass, infrared absorbing sheet glass, infrared reflecting sheet glass, and green glass.

Examples of the intermediate layer to be used for the glass component of the present invention is not particularly limited, and examples thereof include resins such as vinyl acetate resin-based, vinyl chloride-vinyl acetate copolymer-based, ethylene-vinyl acetate copolymer-based, polyvinyl alcohol, polyvinyl butyral, polyvinyl acetal, polyvinyl ether, nitrile rubber-based, styrenebutadiene rubber-based, natural rubber-based, chloroprene rubber-based, polyamide-based,

epoxy resin-based, polyurethane-based, acrylic resin-based, cellulose-based, polyvinyl chloride, polyacrylic acid ester, and polyisobutylene adhesives. To these intermediate layers may be added a pressure-sensitive adhesiveness adjusting agent, a plasticizer, a heat stabilizer, an antioxidant, an ultraviolet absorber, an antistatic agent, a lubricant, a colorant, a crosslinking agent, and the like. By providing the intermediate layer, functions such as adhesion between glass and the laminated film, designability, durability, weather resistance, and impact resistance of a laminated glass can be enhanced.

The intermediate layer to be used in the glass component of the present invention may contain a component that enhances designability. Examples of the component that enhances designability include colorants such as azo pigments, polycyclic pigments, lake pigments, nitro pigments, nitroso pigments, aniline black, alkali blue, phthalocyanine pigments, cyanine pigments, azo dyes, anthraquinone dyes, quinophthalone dyes, methine dyes, fused polycyclic dyes, reactive dyes, cationic dyes, lanthanum hexaboride, indium tin oxide, antimony tin oxide, and cesium tungsten oxide.

Examples of the method for molding the intermediate layer include extrusion lamination, hot melt lamination, thermal lamination, press lamination, vacuum lamination, and autoclave lamination. The extrusion lamination is a method in which a molten laminated film and a molten intermediate layer are separately extruded from a die into a film shape and laminated on glass, and a molded body is passed between two rolls to be molded. The hot melt lamination is a molding method in which an intermediate layer melted by heat is applied to a laminated film or glass, and the laminated film and the glass are laminated. The thermal lamination is a molding method in which a laminated film, an intermediate layer, and glass are pressure-bonded and laminated while being heated with a heating roll. The press lamination is a molding method in which a laminated film, an intermediate layer, and glass are heated and pressure-bonded by a press machine to be laminated. The vacuum lamination is a molding method in which a laminated film, an intermediate layer, and glass are heated, and then these are pressed and laminated with the inside of the apparatus brought into a vacuum state. The autoclave lamination is a molding method in which a laminated film, an intermediate layer, and glass are heated, and then laminated by pressurizing the inside of the apparatus with a gas or the like.

The glass component of the present invention preferably satisfies $3 \leq d1/d2 \leq 100$, where d1 represents the thickness of the intermediate layer 1, and d2 represents the thickness of the intermediate layer 2. Setting the thickness of the two intermediate layers within a suitable range is preferable because the resulting glass component can suppress double image of a projected image when the glass component is used for a projected image display member having a P-polarized wave reflection characteristic and a projection member such as a head-up display (HUD). The thickness of the intermediate layer is preferably 10 $\mu$m to 1 mm.

The glass component of the present invention preferably satisfies $1.5 \leq d3/d4 \leq 10$, where d3 represents the thickness of the glass 1 and d4 represents the thickness of the glass 2. Setting the thickness of the two pieces of glass within a suitable range is preferable because the resulting glass component can suppress double image of a projected image when the glass component is used for a projected image display member having a P-polarized wave reflection characteristic and a projection member such as a head-up display (HUD). The thickness of the glass is preferably 0.5 mm to 5.0 mm.

The glass component using the thus-obtained laminated film is, for example, superior in inner heat shielding performance and superior in transparency, and thus is particularly suitable for heat shielding glass to be used for automobiles, building windows, and the like. In addition, when the glass component is used for a projected image display member having a P-polarized wave reflection characteristic and a projection member such as a head-up display (HUD), these are suitable for a display device having a high display property for a projected image and good visibility of the surrounding scenery. That is, the automobile and the building window of the present invention include the glass component of the present invention.

EXAMPLES

Hereinafter, the laminated film of the present invention will be described specifically with reference to examples. However, the laminated film of the present invention is not limited to such an aspect.

[Methods for measurement of physical properties and methods for evaluation of effects]

The methods for evaluation of physical property values and the methods for evaluation of effects are as follows.

(1) Identification of substrate

The composition of the resin constituting a substrate was confirmed by the following method. First, the presence or absence of peaks derived from bonds between atoms in the structure of the resin is confirmed by Fourier transform infrared spectroscopy (FT-IR). Further, positions of chemical shifts derived from the positions of hydrogen atoms in the structure of the resin and proton-absorption line area derived from the number of hydrogen atoms were confirmed by proton-nuclear magnetic resonance spectroscopy ($^1$H-NMR). These results were collectively and comprehensively

confirmed and the substrate was identified. If necessary, a mass peak may be confirmed by gas chromatography-mass spectrometry (GC-MS). The above analyses were performed using samples obtained by shaving the laminated film with a blade knife.

(2) Thickness of resin layer

A laminated film was stained with $RuO_4$ and/or $OsO_4$. Next, the laminated film was frozen and cut in the film thickness direction, affording 10 ultrathin section samples for observing a section of a resin layer. The section of each sample was observed with a transmission electron microscope (TEM: H7100FA manufactured by Hitachi, Ltd.) at a magnification of 10,000 to 1,000,000 times, affording a sectional photograph. The thickness of the resin layer of each sample was measured from the sectional photograph using the length measuring function of the microscope, and the measured values of the thicknesses of the resin layers of the ten samples were averaged, and the average was taken as the thickness of the resin layer of the laminated film.

(3) Derivation of Xs, Xc, Xb, XO, and XOs of resin layer

First, the composition distribution in the depth direction was analyzed from the surface layer side of the resin layer of a laminated film using an analysis method GCIB-TOF-SIMS (GCIB: gas cluster ion beam, TOF-SIMS: time-of-flight secondary ion mass spectrometry). The measurement conditions were set as follows.

<Sputtering conditions>

Ion source: argon gas cluster ion beam (Ar-GCIB)

<Detection conditions>

Primary ion: $Bi^{3++}$ (25 kV)
Secondary ion polarity: positive
Mass range: m/z 0 to 1500
Measurement range: $300 \times 300\ \mu m^2$
Measurement vacuum degree: $4 \times 10^{-7}$ Pa or less

In the measurement under the above conditions, a profile of the positive secondary ion absolute intensity of each component with respect to the sputtering time of GCIB-TOF-SIMS was acquired. Among them, in the profile of the positive secondary ion absolute intensity corresponding to the main component of the substrate identified in (1), 100 consecutive approximate straight lines were calculated, and an average value of 100 points located on the innermost layer side (substrate side) among 100 points having a slope of $\pm 15$ or less was defined as "substrate absolute intensity". The sputtering time at which the intensity was 1/2 of the "substrate absolute intensity" calculated above was derived and defined as "1/2 intensity sputtering time", and this point was defined as the boundary between the resin layer and the substrate. That is, it is meant that the sputtering time from 0 to 1/2 intensity sputtering time indicates a component distribution of the resin layer and the sputtering time after the 1/2 intensity sputtering time indicates a component distribution of the substrate.

Next, a method for converting the sputtering time in the profile of the positive secondary ion absolute intensity of GCIB-TOF-SIMS into the thickness of the resin layer will be described. A profile of the positive secondary ion absolute intensity of each component with respect to the resin layer thickness of GCIB-TOF-SIMS was acquired by dividing the resin layer thickness determined in the measurement of (2) above by the 1/2 intensity sputtering time calculated above to determine an etching rate, and converting the sputtering time to the resin layer thickness on the basis of the etching rate.

Next, a method for converting the positive secondary ion absolute intensity of each component into the positive secondary ion normalized intensity of each component will be described. Normalization is performed by taking the substrate absolute intensity calculated by the above method as 1, and the positive secondary ion normalized intensity of each component is acquired from the positive secondary ion absolute intensity of each component. Of the positive secondary ion normalized intensities of each component, the normalized intensity at a position of 20% of the thickness from the surface layer of the resin layer was denoted by Xs, the normalized intensity at a position of 50% of the thickness from the surface layer of the resin layer was denoted by Xc, and the normalized intensity at a position of 80% of the thickness from the surface layer of the resin layer was denoted by Xb. In addition, the normalized intensity of the oxazoline compound on the surface layer of the resin layer was denoted by XO, and the normalized intensity at a position of 20% of

the thickness from the surface layer of the resin layer was denoted by XOs.

Examples of the positive secondary ion of the acrylic resin include $^{69}C_4H_5O^+$, examples of the positive secondary ion of the polyester resin include $^{104}C_7H_4O^+$, examples of the positive secondary ion of the urethane resin include $^{122}C_7H_8NO^+$, and examples of the positive secondary ion of an oxazoline compound or a chemical structure derived from an oxazoline compound include $^{112}C_6H_{10}NO^+$. Here, the "position of 20% of the thickness from the surface layer of the resin layer" refers to a thickness position closest to (the thickness of the resin layer) × 20/100 as viewed from the surface of the resin layer. Similarly, the "position of 50% of the thickness from the surface layer of the resin layer" refers to a thickness position closest to (the thickness of the resin layer) × 50/100 as viewed from the surface of the resin layer, the "position of 80% of the thickness from the surface layer of the resin layer" refers to a thickness position closest to (the thickness of the resin layer) × 80/100 as viewed from the surface of the resin layer, and the "surface layer of the resin layer" refers to the surface of the resin layer.

(4) AFM elastic modulus of resin layer

Measurement was performed using NanoScope V manufactured by Bruker AXS. The measurement was performed in accordance with the appended "Measurement Operating Procedure of PeakForce QNM", and the measurement conditions were as follows. The measurement at 25°C was performed using a sample left standing for 24 hours in a room temperature-controlled to 25°C, and the measurement at - 20°C was performed immediately after a sample left standing for 24 hours in a portable freezer temperature-controlled to -20°C was taken out. All the measurements were performed in an atmosphere conditioned at a room temperature of 23°C and a relative humidity of 65%. This measurement was performed 10 times, the average value of the measurements was taken as the AFM elastic modulus (P(25), P(-20)) of the resin layer at each temperature, and ΔP (P(-20) - P(25)) and the elastic modulus ratio P' (P(-20)/P(25)) were calculated.

Probe: RTESPA-300
Scan Size: 1 nm
Scan Rate: 1 Hz
Peak Force Setpoint: 40.00 mN.

(5) Melting point, crystallization temperature, enthalpy of fusion, minute endothermic peak, and glass transition temperature of resin layer

5 mg of a sample was collected by shaving with a cutter or a blade knife, and was measured and calculated in accordance with JIS K 7122 (1987) using a differential scanning calorimeter (DSC) Robot DSC-RDC220 manufactured by Seiko Instruments & Electronics Ltd. More specifically, the temperature of the sample was raised from 25°C to 300°C at 5°C/min, a peak near the melting point on the lower temperature side than the melting point at this time was defined as a minute endothermic peak, and the integral value from the baseline in the range of the melting point ± 20°C was defined as an enthalpy of fusion. In addition, the melting point as used here is a point at which the difference from the baseline of the DSC chart is minimum. The crystallization temperature was defined by a point at which the difference from the baseline of the DSC chart was maximum on the exothermic peak located on the lower temperature side than the melting point. The minute endothermic peak is observed in the first run of DSC, and is not observed in the second run in which the thermal history is eliminated by once raising the temperature to the melting point or higher, and thus can be confirmed by comparing both DSC charts. Similarly, the glass transition temperature of the resin layer was measured and calculated in accordance with JIS K 7122 (1987). More specifically, the glass transition temperature was defined by a temperature at the point where the straight line that is at the same distance in the vertical direction from the extensions of the baseline on the lower temperature side and the baseline on the higher temperature side intersects the curve that changes stepwise due to glass transition.

(6) Water droplet contact angle

The water droplet contact angle was measured in accordance with the static drop method described in JIS R3257:1999. First, a laminated film was left to stand for 24 hours in an atmosphere conditioned at a room temperature of 23°C and a relative humidity of 65%. Thereafter, under the same atmosphere, the contact angle of pure water with respect to the surface side of the resin layer of the laminated film was measured at five points by a 2/θ method using a contact angle meter CA-D type (manufactured by Kyowa Interface Science Co., Ltd.). The measurement was performed within 10 seconds after the pure water came into contact with the resin layer. The measured values at three points obtained by excluding the maximum value and the minimum value of the measured values at five points were averaged, and a value twice the measured value was taken as the water droplet contact angle.

(7) Confirmation of structure of resin layer

The structure of a resin layer was confirmed by the following method. To specify the urethane structure and the structures of the following formulas (1) to (5), the weight peaks of an aliphatic isocyanate compound and a polyol compound derived via cleavage of a urethane linkage portion were confirmed by gas chromatography-mass spectrometry (GC-MS). For the structures of the following formulas (1) to (5), the presence or absence of weight peaks derived from the structures were similarly confirmed. Next, the presence or absence of peaks derived from the isocyanate compound, the polyol compound, and the bonds between atoms of the structures of the following formulas (1) to (5) was confirmed by Fourier-transform infrared spectroscopy (FT-IR). Further, positions of chemical shifts derived from the positions of hydrogen atoms of an isocyanate compound, a polyol compound, an oxazoline compound, and the structures of the following formulas (1) to (5) and proton-absorption line area derived from the number of hydrogen atoms were confirmed by proton-nuclear magnetic resonance spectroscopy ($^1$H-NMR). These results were comprehensively confirmed, and the structure of the resin was confirmed. The above analyses were performed for samples obtained by shaving the resin layer with a blade knife. The structures of an acrylic modified polyester resin, an oxazoline compound or a chemical structure derived from an oxazoline compound, and a melamine compound were also confirmed in the same manner as in the above examples.

[Chem. 2]

Formula (1) 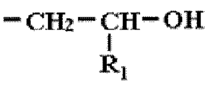

$R_1$ : H or $CH_3$

Formula (2) 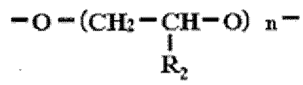

$R_2$ : H or $CH_3$, n : positive integer

Formula (3) 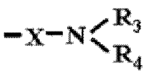

X : -C(=O)- or $CH_2$

$R_3$、$R_4$ : H, $CH_3$, $C_2H_5$, $CH(CH_3)_2$ or $CH_2OH$

Formula (4) 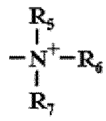

$R_5$、$R_6$、$R_7$ : $CH_3$ or $C_2H_5$

Formula (5) 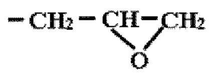

(8) Preparation of samples for peel force test (25°C, - 20°C) of EVA and PVB

A laminated film was cut into a size 10 cm long and 3 cm wide, and EVA ("Soarnol" (registered trademark) DC3203 manufactured by Mitsubishi Chemical Corporation) and PVB ("S-LEC Film" HI manufactured by Sekisui Chemical Co., Ltd.) were cut into a size 40 cm long and 1 cm wide. EVA and PVB were stacked on the center of the laminated film in the width direction such that their long sides were parallel to each other, and the protruding portion was sandwiched between protective films ("Cerapeel" (registered trademark) #25WZ (RX) manufactured by TORAY ADVANCED FILM Co., Ltd.). This was preheated for 1 minute in a hot air oven heated to 140°C, and then laminated at a speed of 300 mm/min with a laminator (MRK-600 manufactured by MCK Co., Ltd.) heated to 140°C, and thus a sample was obtained.

(9) Peel force test (25°C, -20°C) of EVA and PVB

Measurement was performed according to the following procedure using an adhesion/film peeling analyzer VPA-2 manufactured by Kyowa Interface Science Co., Ltd. First, a sample produced in (8) was fixed to a measurement unit with a tape together with an attached stainless steel plate, and the EVA and PVB portions protruding from the laminated film portion of the sample were fixed to a sample fixing plate. Thereafter, peel force was measured under the following measurement conditions, and the average value of the peel force in a 20 mm zone where the peel force was the most uniform in the measurement distance of 100 mm was obtained. The same measurement was performed five times for each sample, and the average value of the five measurements was defined as the peel force (N/mm), and evaluation was performed according to the following evaluation criteria (⊙ and o were regarded as good results). The peel force test at 25°C was performed using samples that had been left to stand for 24 hours in a room temperature-controlled to 25°C. The peel force test at -20°C was performed immediately after a sample and an attached stainless steel plate were left to stand in a portable freezer temperature-controlled to -20°C for 24 hours and then taken out.

<Measurement conditions>

Load cell: 100 N
Peeling speed: 300 mm/min
Peeling angle: 180°
Sample width (tape width): 10 mm
Measurement distance: 100 mm.

<Evaluation criteria>

⊙: higher than 1.0 N/mm
◦: 0.8 N/mm or more and 1.0 N/mm or less
×: less than 0.8 N/mm.

(10) Layer thickness, number of laminated layers, laminated structure

The layer structure of a film was confirmed by transmission electron microscope (TEM) observation of a sample obtained by cutting out a section parallel to the thickness direction (a section in the thickness direction) using a microtome. More specifically, using a transmission electron microscope H-7100FA type (manufactured by Hitachi, Ltd.), a section of a film in the thickness direction was observed at a magnification of 10,000 to 40,000 times at an accelerating voltage of 75 kV, a photograph was taken. Then, the layer structure was confirmed using the obtained image and the scale function of the TEM, and the thickness of each layer was measured. In some occasions, a known staining technique using $RuO_4$, $OsO_4$, or the like was used to obtain an increased contrast. The thickness direction refers to a direction perpendicular to a film surface.

(11) Blocking

A film was cut into two pieces being 30 mm wide and 60 mm long, and their surfaces each having a resin layer were superimposed on each other by 40 mm in the longitudinal direction, a weight being 30 mm wide and 40 mm long and weighing 6 kg was placed on the superimposed portion, and the films were treated under an atmosphere of 60°C × 95%RH for 168 hours. After the treatment, the superposed films were peeled off, and evaluated according to the following criteria (⊙, o, and △ were regarded as good results). In the evaluation, for the resistance at the time of peeling, the two films were each held by hand, the resistance at the time of peeling was evaluated sensorially, and whitening and peeling were visually observed.

<Evaluation criteria>

⊙: There was no resistance during peeling, and there was no whitening or peeling on the resin layer surfaces after peeling.
◦: There was slight resistance during peeling, but there was no whitening or peeling on the resin layer surfaces after peeling.
△: There was resistance during peeling, but there was no whitening or peeling on the resin layer surfaces after peeling.
×: There was resistance during peeling, and whitening or peeling was observed on the resin layer surfaces after peeling.

(12) Production of laminated glass

Using LAMINATOR 0303S manufactured by Nisshinbo Industries, Inc., a transparent plate glass, an intermediate layer, a film of Example or Comparative Example, an intermediate layer, and a transparent plate glass were stacked in this order, and pressed by holding the stack under the conditions of a temperature of 140°C and 1.5 MPa for 30 minutes. Thus, a laminated glass was produced. The transparent plate glasses used were 100 mm wide and 100 mm long, and each had a thickness described in Tables 3 and 4. PVB films were used as the intermediate layers, and the films each

had a thickness described in Tables 3 and 4.

(13) Production of glass laminate

Using LAMINATOR 0303S manufactured by Nisshinbo Industries, Inc., a transparent plate glass, an intermediate layer, a film of Examples 38 to 41 were stacked in this order, and pressed by holding the stack under the conditions of a temperature of 140°C and 1.5 MPa for 30 minutes. Thus, a glass laminate was produced. The transparent plate glasses used were 100 mm wide and 100 mm long, and each had a thickness described in Tables 3 and 4. PVB films were used as the intermediate layers, and the films each had a thickness described in Tables 3 and 4.

(14) Laminated glass appearance (irregularities)

A laminated glass produced in the above (12) was placed under a fluorescent lamp, and the evaluation portion was visually evaluated from angles of 20°, 50° and 70° with respect to the normal line direction of the evaluation portion. The evaluation criteria are as follows.

◦: No or very slight irregularities were visible.
×: Irregularities were visible.

(15) Reflectance

A sample cut out in a size of 5 cm × 5 cm was subjected to reflectance measurement with a basic configuration using an integrating sphere attached to a spectrophotometer (U-4100 Spectrophotometer) manufactured by Hitachi, Ltd. In this measurement, an auxiliary white plate of aluminum oxide attached to the apparatus was used as a reference. In the reflectance measurement, the sample was placed behind the integrating sphere with the longitudinal direction of the sample in the vertical direction, the reflectance was measured under the following conditions with the resin layer surface of the laminated film as an incidence plane, and the average reflectances in the wavelength band of 400 nm to 700 nm and the wavelength band of 850 nm to 1200 nm were calculated.

<Measurement conditions>

Slit: 2 nm (visible)/automatic control (infrared)
Gain: 2
Scanning speed: 600 nm/min
Start wavelength: 2600 nm
End wavelength: 240 nm
Sampling interval: 1 nm
Incident angle: 10°.

(16) Heat shielding property

The total energy transmittance (Tts) through a laminated glass produced in the above (12) was measured in accordance with ISO 13837:2008 "Road vehicles - Safety glazing materials - Method for the determination of solar transmittance". The total energy transmittance (Tts) through the laminated glass was evaluated in the following four ranks.

⊙: The total energy transmittance (Tts) through a laminated glass is 50% or less.
◦: The total energy transmittance (Tts) through a laminated glass is more than 50% and less than 60%.
△: The total energy transmittance (Tts) through a laminated glass is more than 60% and less than 70%.
×: The total energy transmittance (Tts) through a laminated glass is 70% or more.

(17) Transmittance

Using a spectrophotometer (U-4100 Spectrophotomater) manufactured by Hitachi, Ltd. in the normal mode (solid measurement system), transmittance was measured with the resin layer surface of a laminated film set as an incidence plane under the following conditions, and an average transmittance was determined.

<Measurement conditions>

Slit: 2 nm (visible)/automatic control (infrared)
Gain: 2
Scanning speed: 600 nm/min
Start wavelength: 700 nm
End wavelength: 400 nm
Sampling interval: 1 nm
Incident angle: 0°.

(18) Measurement of R20, R40 and R70

To a spectrophotometer (U-4100 Spectrophotomater) manufactured by Hitachi, Ltd. were attached an accessory angle variable type reflection unit and a Glan-Taylor polarizer, and then reflectance of a P-polarized wave was measured at an incident angle $\theta$ of 20°, 40°, or 70° at 1 nm intervals over a wavelength range of 400 to 700 nm with the resin layer surface of a laminated film set as an incidence plane. From the obtained reflectance, R20, R40, and R70 were determined as average reflectances of the P-polarized wave in the wavelength range of 400 to 700 nm at incident angles of 20°, 40°, and 70°, respectively.

(19) Display property

When a white straight line on a black background was reflected on the laminated glass produced in the above (12) and the glass laminate produced in the above (13) at an incident angle of 70° using a P-polarized wave light source, sensory evaluation for the visibility of the white straight line was carried out, and the visibility in the visual observation was rated in the following three ranks. In the case of a laminated glass, where the thinner one of the two intermediate layers was denoted by d2, the thinner one of the two sheets of glass was denoted by d4, light was incident on the intermediate layer side having the thickness d2 and on the glass side having the thickness d4. Alternatively, in the case of a glass laminate, light was incident on the laminated film side. In the laminated glass, when the thicknesses of the two intermediate layers and the two sheets of glass were the same, the results were the same regardless of the surface to be measured.

⊙: The white straight line was visually recognizable.
◦: Although the white straight line was visually recognizable, the brightness was slightly poor.
×: The white straight line was not visually recognizable.

(20) Double image

When a white straight line on a black background was reflected on the laminated glass produced in the above (12) and the glass laminate produced in the above (13) at an incident angle of 70° using a P-polarized wave light source, the number and appearance of the white straight line recognized were visually evaluated, and rated in the following three ranks.

⊙: One straight line appeared slightly blurred.
◦: Two straight lines were visible, but the two lines were very close.
×: Two straight lines separated by a certain distance were observed.

(21) Average rate of change in shrinkage

Measurement was performed using a thermomechanical analyzer (TMA/SS6000) manufactured by Seiko Instruments Inc. under the following measurement conditions. Samples were cut out in an arbitrary direction in a plane parallel to a film surface, and also cut out in every direction rotated from that arbitrary direction to 180° at 5° intervals in an in-plane direction parallel to the film surface. For each data, a shrinkage S(T) at each temperature was calculated using Formula (9) such that at least one or more data were obtained per 1°C, and the shrinkage was plotted on the vertical axis and the temperature was plotted on the horizontal axis, and a thermal shrinkage curve was thereby obtained. The measurement was performed 3 times in each direction, and the direction in which S(150) was the largest was defined as the X direction.

<Measurement conditions>

Specimen size: 4 mm wide, 15 mm long
Heating range: 25 to 200°C
Heating rate: 10°C/min
Measurement load: 19.8 N
Temperature: 23°C, relative humidity: 65%, in the air

[Math. 4]

$$S(T) = (L(25) - L(T)) \times 100/L(25) \quad (9)$$

Here, L(T) is a sample length at T°C.

From the obtained shrinkages S(T), the average rate of change in shrinkage from 100°C to 150°C (average rate of change in shrinkage) was calculated using Formula (10).
[Math. 5]

$$\text{Average rate of change in shrinkage} = |S(150) - S(100)|/(150 - 100) \ (10) \quad (10)$$

[Resin used for film]

Resin 1: Crystalline polyethylene terephthalate resin exhibiting a glass transition temperature of 78°C, a melting point of 254°C, a crystallization temperature of 180°C, and an enthalpy of fusion of 40 J/g
Resin 2: Amorphous polyethylene terephthalate resin obtained by copolymerizing 33 mol% of cyclohexanedimethanol, exhibiting a glass transition temperature of 80°C
Resin 3: Amorphous polyethylene terephthalate resin blend obtained by blending a polyethylene terephthalate resin obtained by copolymerizing 29 mol% of spiroglycol and 21 mol% of cyclohexanedicarboxylic acid and exhibiting a glass transition temperature of 80°C with Resin 1 at a ratio of 70 : 30
Resin 4: Amorphous copolymerized polynaphthalate resin having a glass transition temperature of 81°C and obtained using 70 mol% of 2,6-naphthalenedicarboxylic acid and 30 mol% of isophthalic acid as dicarboxylic acid components, and 98 mol% of ethylene glycol and 2 mol% of polyethylene glycol having a molecular weight of 400 as diol components

(Example 1)

· Coating liquid containing acrylic modified polyester resin:

50 parts by mass of terephthalic acid, 50 parts by mass of isophthalic acid, 50 parts by mass of ethylene glycol, and 30 parts by mass of neopentyl glycol were charged into a nitrogen-purged reactor together with 0.3 parts by mass of antimony trioxide and 0.3 parts by mass of zinc acetate as polymerization catalysts. Thereafter, a polymerization reaction was performed for 12 hours under the conditions of normal pressure and a temperature of 190 to 220°C while removing water, and polyester glycol was thereby obtained. Next, 5 parts by mass of 5-sodium sulfoisophthalic acid and xylene as a solvent were added to the obtained polyester glycol, and the mixture was charged in a reactor. The mixture was polymerized for 3 hours while the xylene was distilled off under reduced pressure conditions of a pressure of 0.2mmHg and a temperature of 260°C, and thus a polyester resin component was thereby obtained. This polyester resin component was dissolved in water containing aqueous ammonia and butyl cellulose, affording an aqueous dispersion containing the polyester resin component. Next, 40 parts by mass of methyl methacrylate and 10 parts by mass of methacrylamide, 50 parts by mass in total, were added to the aqueous dispersion containing the polyester resin component so as to attain a mass ratio of acrylic resin component/polyester resin component = 50/50. Furthermore, 5 parts by mass of benzoyl peroxide was added as a polymerization initiator, and a polymerization reaction was performed at 70 to 80°C for 3 hours in a nitrogen-purged reactor, affording a coating liquid containing an acrylic modified polyester resin.

· Coating liquid containing urethane resin:

A four-necked flask equipped with a reflux condenser, a nitrogen inlet tube, a thermometer, and a stirrer was

charged with 70 parts by mass of 1,6-hexane diisocyanate as an aliphatic polyisocyanate compound, 30 parts by mass of polyisobutylene glycol as a polyol compound, 60 parts by mass of acetonitrile and 30 parts by mass of N-methylpyrrolidone as a solvent. Next, under a nitrogen atmosphere, the temperature of the reaction liquid was adjusted to 75 to 78°C, 0.06 parts by mass of stannous octoate was added as a reaction catalyst, and the mixture was reacted for 7 hours. Then, this mixture was cooled to 30°C, affording an isocyanate group-terminated aliphatic urethane resin. Next, water was added to a reaction vessel equipped with a homodisper capable of stirring at high speed and adjusted to 25°C, and while stirring and mixing at 2000rpm, the isocyanate group-terminated aliphatic urethane resin was added and dispersed in water. Thereafter, acetonitrile and water were partially removed under reduced pressure to prepare a coating liquid containing a urethane resin (in Table 1-1, this is abbreviated as Urethane 1).

· Coating liquid containing oxazoline compound:

A flask equipped with a reflux condenser, a nitrogen inlet tube, a thermometer, a stirrer, and a dropping funnel was charged with 782.4 parts by mass of deionized water and 128 parts by mass of a surfactant (a 15% by mass aqueous solution of "HITENOL" (registered trademark) N-08 manufactured by DKS Co., Ltd.), the pH of the mixture was adjusted to 9 with aqueous ammonia (28%), and the mixture was heated to 70°C while a nitrogen gas was fed. Then, 64 parts by mass of a 5% aqueous solution of potassium persulfate was poured, and subsequently a monomer mixture of 320 parts by mass of methyl methacrylate, 160 parts by mass of ethyl acrylate, 32 parts by mass of styrene, and 128 parts by mass of 2-isopropenyl-2-oxazoline, which had been mixed and stirred in advance in another flask, was dropped over 3 hours. During the reaction, the reaction liquid temperature was maintained at 70°C under a nitrogen atmosphere. After completion of the dropwise addition, the reaction liquid was kept at that temperature for 2 hours, then the reaction liquid temperature was raised to 80°C, and stirring was continued for 1 hour to complete the reaction. Thereafter, the mixture was cooled and diluted in a mixed solvent of propylene glycol monomethyl ether and water (20/80 (mass ratio)) to prepare a coating liquid containing an oxazoline compound.

· Resin composition:

The coating liquid containing an acrylic modified polyester resin, the coating liquid containing a urethane resin, the coating liquid containing an oxazoline compound, and a melamine compound "NIKALAC" (registered trademark) MW-035 (manufactured by SANWA Chemical Co., Ltd.) were mixed such that the solid mass ratio was acrylic modified polyester resin/urethane resin/oxazoline compound/melamine compound = 90/10/60/10, and the total solid component content was adjusted to 10% by mass, and thus coating liquid A was obtained. Furthermore, to impart slipperiness to a resin layer surface, silica particles having a number average particle diameter of 170 nm ("SNOWTEX" (registered trademark) MP-2040 manufactured by Nissan Chemical Corporation) as inorganic particles were added in an amount of 2 parts by mass based on 100 parts by mass of the solid component of the entire coating liquid A. Furthermore, to improve the coatability of a resin composition onto a polyester film, a fluorine-based surfactant ("PLAS COAT" (registered trademark) RY-2 manufactured by GOO Chemical Co., Ltd.) was added in an amount of 0.03 parts by mass based on 100 parts by mass of the entire coating liquid A. Thereafter, the mixture was diluted with a mixed solvent of isopropyl alcohol and water (20/80 (mass ratio)) so as to have a solid content of 5% by mass, affording a resin composition.

· Laminated film:

Resin 1 was used as a crystalline thermoplastic resin for constituting layer A (hereinafter, also referred to as resin A), and resin 2 was used as a thermoplastic resin for constituting layer B (hereinafter, also referred to as resin B). Resins A and B were melted at 280°C in separate extruders, and foreign matters and the like were removed through 5 sheets of FSS type leaf disk filters. Thereafter, while being metered by a gear pump such that the discharge ratio was resin A/resin B = 1/1.07, both resins were joined with a 401-layer feed block, and 401 layers in total of resin A and resin B were laminated alternately in the thickness direction such that the outermost layers on both sides were resin A. At this time, the layer thicknesses of layer A and layer B were designed such that the reflectance spectrum in the wavelength range of 380 nm to 780 nm was flat. Then, the resulting molten laminate was fed to a T-die and molded into a sheet form, and then, while an electrostatic voltage of 8 kV was applied with a wire, the molded laminate was quenched and solidified on a casting drum having a surface temperature maintained at 25°C, and an unstretched film was thereby obtained. This unstretched film was longitudinally stretched at a temperature of 90°C and a magnification of 3.5 times utilizing a circumferential speed difference between rolls, and then temporarily cooled, affording a uniaxially stretched film. Subsequently, both surfaces of the uniaxially stretched film were subjected to corona discharge treatment in air, and the resin composition was applied to the treated surfaces using a bar coater such that the application thickness was about 6 μm. Thereafter, the uniaxially stretched film was guided to a tenter with both edges in the width direction grasped with clips, stretched transversely under conditions of a temperature of 110°C and a magnification of 4.3 times, then subjected to heat treatment at 210°C, and

further relaxed by 1.6% in the width direction, affording a laminated film having a thickness of 80 μm (in Table 1-3, the film is abbreviated as laminated film 1). The resulting laminated film had a flat reflectance distribution having substantially no reflection at a wavelength of 400 to 700 nm in a visible light region while reflecting infrared rays having a wavelength of 850 to 1200 nm. The evaluation results of the resulting laminated film are shown in Tables 1-1, 1-2, and 1-3, and the characteristics of laminated film 1 are shown in Table 2.

(Example 2)

A laminated film was produced under the same conditions as in Example 1 except that the acrylic resin of the acrylic modified polyester resin was changed to 40 parts by mass of methyl methacrylate and 10 parts by mass of 2-hydroxyethyl methacrylate, 50 parts by mass in total. The composition of the resin composition and the evaluation results of the resulting laminated film are shown in Tables 1-1, 1-2, and 1-3.

(Example 3)

A laminated film was produced under the same conditions as in Example 1 except that the acrylic resin of the acrylic modified polyester resin was changed to 40 parts by mass of methyl methacrylate and 10 parts by mass of ethylene glycol methacrylate, 50 parts by mass in total. The composition of the resin composition and the evaluation results of the resulting laminated film are shown in Tables 1-1, 1-2, and 1-3.

(Example 4)

A laminated film was produced under the same conditions as in Example 1 except that the acrylic resin of the acrylic modified polyester resin was changed to 40 parts by mass of methyl methacrylate and 10 parts by mass of acrylic acid triethylamine, 50 parts by mass in total. The composition of the resin composition and the evaluation results of the resulting laminated film are shown in Tables 1-1, 1-2, and 1-3.

(Example 5)

A laminated film was produced under the same conditions as in Example 1 except that the acrylic resin of the acrylic modified polyester resin was changed to 40 parts by mass of methyl methacrylate and 10 parts by mass of glycidyl acrylate, 50 parts by mass in total. The composition of the resin composition and the evaluation results of the resulting laminated film are shown in Tables 1-1, 1-2, and 1-3.

(Examples 6, 9 to 20, 22 to 28, Comparative Examples 1 to 6)

Laminated films were produced under the same conditions as in Example 1 except that the composition of the resin composition was changed as shown in Table 1-1. The evaluation results of the resulting laminated films are shown in Tables 1-2 and 1-3. As the carbodiimide compound, "CARBODILITE" (registered trademark) V-04 (manufactured by Nisshinbo Chemical Inc.) was used.

(Examples 7 and 8)

Laminated films were produced under the same conditions as in Example 1 except that the acrylic resin of the acrylic modified polyester resin was changed to 50 parts by mass of methyl methacrylate, and the composition of the resin composition was changed as shown in Table 1-1. The evaluation results of the resulting laminated films are shown in Tables 1-2 and 1-3. The polyester-urethane copolymer was obtained by the following procedure.

· Coating liquid containing polyester-urethane copolymer:

100 parts by mass of polyester polyol (adipic acid/3-methyl-1,5-pentanediol), 3.0 parts by mass of trimethylolpropane, 10 parts by mass of dimethylolpropionic acid, and 58 parts by mass of isophorone diisocyanate were reacted in methyl ethyl ketone (MEK), affording a polyester-urethane copolymer. Then, 7.5 parts by mass of triethylamine was mixed therewith and the mixture was charged into water. The polyester-urethane copolymer was dispersed in water, and elongated with ethylenediamine, affording a dispersion. Methyl ethyl ketone was distilled off, and a coating liquid containing a polyester-urethane copolymer containing 30% by mass of a nonvolatile component was thereby obtained.

(Example 21)

A coating liquid containing a urethane resin was prepared in the same manner as in Example 1 except that isophorone diisocyanate was used as the aliphatic polyisocyanate compound of the coating liquid containing a urethane resin (in Table 1-1, the resulting coating liquid is abbreviated as urethane 2), and a film was produced under the same conditions as in Example 1 except that the composition of the resin composition was changed as shown in Table 1-1. The evaluation results of the resulting film are shown in Tables 1-2 and 1-3.

(Comparative Example 7)

A laminated film was produced under the same conditions as in Example 1 except that the composition of the resin composition was set by mixing compounds A, B, C and D with water at a ratio in % by weight of compound A : compound B : compound C : compound D = 43 : 43 : 4 : 10, and adjusting the solid concentration to 3% by mass where compound A was 70 mol% of methyl methacrylate/20 mol% of ethyl acrylate/10 mol% of 2-hydroxyethyl methacrylate, compound B was 32 mol% of terephthalic acid/12 mol% of isophthalic acid/6 mol% of 5-sodium sulfoisophthalic acid/46 mol% of ethylene glycol/4 mol% of diethylene glycol, compound C was 1,3-bis(N,N-diglycidylamine)cyclohexane, and compound D was polyoxyethylene (n = 7) lauryl ether. The composition of the resin composition and the evaluation results of the resulting laminated film are shown in Tables 1-1, 1-2, and 1-3.

[Table 1-1]

| | Configuration of acrylic modified polyester resin (Content (parts by mass)) | | Type of urethane resin | Configuration of resin composition (Content (parts by mass)) | | | | | |
|---|---|---|---|---|---|---|---|---|---|
| | Acrylic resin component | Polyester resin component | | Acrylic modified polyester resin | Urethane resin | Polyester-urethane copolymer | Oxazoline compound | Melamine compound | Carbodiimide compound |
| Example 1 | 50 | 50 | Urethane 1 | 90 | 10 | - | 60 | 10 | - |
| Example 2 | 50 | 50 | Urethane 1 | 90 | 10 | - | 60 | 10 | - |
| Example 3 | 50 | 50 | Urethane 1 | 90 | 10 | - | 60 | 10 | - |
| Example 4 | 50 | 50 | Urethane 1 | 90 | 10 | - | 60 | 10 | - |
| Example 5 | 50 | 50 | Urethane 1 | 90 | 10 | - | 60 | 10 | - |
| Example 6 | 50 | 50 | Urethane 1 | 90 | 10 | - | 60 | - | - |
| Example 7 | 100 | - | - | 40 | - | 60 | 60 | 10 | - |
| Example 8 | 100 | - | - | 40 | - | 60 | 60 | - | - |
| Example 9 | 50 | 50 | Urethane 1 | 90 | 10 | - | 120 | 10 | - |
| Example 10 | 50 | 50 | Urethane 1 | 90 | 10 | - | 120 | - | - |
| Example 11 | 85 | 15 | Urethane 1 | 90 | 10 | - | 60 | - | - |
| Example 12 | 90 | 10 | Urethane 1 | 90 | 10 | - | 60 | - | - |
| Example 13 | 50 | 50 | Urethane 1 | 30 | 70 | - | 60 | - | - |
| Example 14 | 50 | 50 | Urethane 1 | 10 | 90 | - | 60 | - | - |
| Example 15 | 10 | 90 | Urethane 1 | 90 | 10 | - | 60 | - | - |
| Example 16 | 15 | 85 | Urethane 1 | 90 | 10 | - | 60 | 20 | - |
| Example 17 | 50 | 50 | Urethane 1 | 10 | 90 | - | 30 | - | - |
| Example 18 | 50 | 50 | Urethane 1 | 90 | 10 | - | 30 | 20 | - |
| Example 19 | 50 | 50 | Urethane 1 | 90 | 10 | - | 30 | - | - |
| Example 20 | 15 | 85 | Urethane 1 | 90 | 10 | - | 60 | 10 | - |
| Example 21 | 50 | 50 | Urethane 2 | 90 | 10 | - | 60 | 10 | - |
| Example 22 | 50 | 50 | Urethane 1 | 90 | 10 | - | 60 | 30 | - |
| Example 23 | 50 | 50 | Urethane 1 | 90 | 10 | - | 60 | - | 20 |
| Example 24 | 50 | 50 | Urethane 1 | 90 | 10 | - | 80 | 10 | - |
| Example 25 | 50 | 50 | Urethane 1 | 90 | 10 | - | 20 | - | - |
| Example 26 | 50 | 50 | Urethane 1 | 90 | 10 | - | 40 | 10 | - |
| Example 27 | 90 | 10 | Urethane 1 | 90 | 10 | - | 20 | - | - |
| Example 28 | 50 | 50 | Urethane 1 | 90 | 10 | - | 10 | - | - |
| Comparative Example 1 | 50 | 50 | Urethane 1 | 90 | 10 | - | - | - | - |
| Comparative Example 2 | 50 | 50 | Urethane 1 | 90 | 10 | - | - | 60 | - |
| Comparative Example 3 | 50 | 50 | Urethane 1 | 90 | 10 | - | - | - | 60 |
| Comparative Example 4 | - | 100 | Urethane 1 | 90 | 10 | - | 60 | - | - |
| Comparative Example 5 | 100 | - | Urethane 1 | 90 | 10 | - | 60 | - | - |
| Comparative Example 6 | 50 | 50 | - | 100 | - | - | 60 | - | - |
| Comparative Example 7 | - | - | - | - | - | - | - | - | - |

In Examples 7 and 8 and Comparative Example 6, the acrylic resin is contained instead of the acrylic modified polyester resin, and in Comparative Example 5, the polyester resin is contained instead of the acrylic modified polyester resin. Therefore, in the tables, the acrylic modified polyester resin in these Examples and Comparative Examples shall be replaced with the acrylic resin and the polyester resin, respectively.

[Table 1-2]

| | Positive secondary ion intensity ratio of acrylic resin component | | Positive secondary ion intensity ratio of polyester resin component | | Positive secondary ion intensity ratio of urethane resin component | | Positive secondary ion intensity ratio of oxazoline compound | Presence or absence of structures of formulas (1) to (5) of Chem. 1 | | | | |
|---|---|---|---|---|---|---|---|---|---|---|---|---|
| | Xs/Xc | Xb/Xc | Xs/Xc | Xb/Xc | Xs/Xc | Xb/Xc | XO/XOs | Formula (1) | Formula (2) | Formula (3) | Formula (4) | Formula (5) |
| Example 1 | 1.0 | 0.9 | 1.6 | 1.5 | 1.2 | 0.9 | 1.6 | - | - | ○ | - | - |
| Example 2 | 1.1 | 0.9 | 1.5 | 1.5 | 1.2 | 0.9 | 1.6 | ○ | - | - | - | - |
| Example 3 | 1.1 | 0.9 | 1.6 | 1.6 | 1.1 | 1.0 | 1.6 | - | ○ | - | - | - |
| Example 4 | 1.1 | 0.9 | 1.4 | 1.5 | 1.1 | 1.0 | 1.6 | - | - | - | ○ | - |
| Example 5 | 1.0 | 0.9 | 1.5 | 1.5 | 1.1 | 1.0 | 1.6 | - | - | - | - | ○ |
| Example 6 | 1.0 | 0.9 | 1.5 | 1.5 | 1.3 | 0.9 | 1.6 | - | - | ○ | - | - |
| Example 7 | 1.2 | 0.9 | 1.5 | 1.8 | 1.1 | 1.0 | 1.6 | - | - | - | - | - |
| Example 8 | 1.1 | 0.9 | 1.4 | 1.7 | 1.1 | 1.0 | 1.6 | - | - | - | - | - |
| Example 9 | 1.4 | 1.6 | 1.0 | 1.8 | 0.9 | 1.2 | 3.5 | - | - | ○ | - | - |
| Example 10 | 1.6 | 1.4 | 1.1 | 1.7 | 1.0 | 1.1 | 3.5 | - | - | ○ | - | - |
| Example 11 | 1.1 | 0.9 | 1.4 | 1.5 | 1.1 | 1.0 | 1.6 | - | - | ○ | - | - |
| Example 12 | 1.2 | 0.9 | 1.5 | 1.5 | 1.1 | 1.0 | 1.6 | - | - | ○ | - | - |
| Example 13 | 1.1 | 0.9 | 1.2 | 1.4 | 1.1 | 1.0 | 1.6 | - | - | ○ | - | - |
| Example 14 | 1.0 | 0.9 | 1.4 | 1.5 | 1.3 | 0.9 | 1.6 | - | - | ○ | - | - |
| Example 15 | 1.0 | 0.8 | 1.5 | 1.8 | 0.7 | 1.2 | 1.6 | - | - | ○ | - | - |
| Example 16 | 1.2 | 1.0 | 1.4 | 1.6 | 0.7 | 1.4 | 1.6 | - | - | ○ | - | - |
| Example 17 | 1.0 | 0.9 | 1.4 | 1.5 | 1.0 | 1.3 | 1.0 | - | - | ○ | - | - |
| Example 18 | 1.7 | 0.9 | 1.0 | 1.9 | 1.3 | 1.0 | 1.0 | - | - | ○ | - | - |
| Example 19 | 1.8 | 1.0 | 1.0 | 1.8 | 1.1 | 1.3 | 1.0 | - | - | ○ | - | - |
| Example 20 | 1.1 | 1.0 | 1.4 | 1.6 | 0.9 | 1.3 | 1.6 | - | - | ○ | - | - |
| Example 21 | 1.0 | 0.9 | 1.6 | 1.5 | 1.2 | 0.9 | 1.6 | - | - | ○ | - | - |
| Example 22 | 1.0 | 0.9 | 1.5 | 1.5 | 1.1 | 1.0 | 1.6 | - | - | ○ | - | - |
| Example 23 | 1.6 | 0.8 | 1.5 | 1.6 | 0.7 | 1.4 | 1.6 | - | - | ○ | - | - |
| Example 24 | 1.4 | 1.6 | 1.0 | 1.8 | 1.0 | 1.1 | 2.6 | - | - | ○ | - | - |
| Example 25 | 1.4 | 0.6 | 0.9 | 2.0 | 0.7 | 1.2 | 0.8 | - | - | ○ | - | - |
| Example 26 | 1.5 | 1.0 | 1.2 | 1.6 | 1.3 | 1.0 | 1.1 | - | - | ○ | - | - |
| Example 27 | 2.0 | 0.3 | 0.6 | 2.1 | 1.1 | 1.0 | 0.8 | - | - | ○ | - | - |
| Example 28 | 1.4 | 0.6 | 0.8 | 2.5 | 0.9 | 0.8 | 0.5 | - | - | ○ | - | - |
| Comparative Example 1 | 1.4 | 0.4 | 0.4 | 2.6 | 0.8 | 0.7 | - | - | - | ○ | - | - |
| Comparative Example 2 | 1.4 | 0.4 | 0.4 | 2.6 | 0.8 | 0.7 | - | - | - | ○ | - | - |
| Comparative Example 3 | 1.4 | 0.4 | 0.4 | 2.6 | 0.8 | 0.7 | - | - | - | ○ | - | - |
| Comparative Example 4 | - | - | 1.0 | 1.1 | 0.9 | 1.3 | 1.6 | - | - | ○ | - | - |
| Comparative Example 5 | 1.1 | 0.5 | - | - | 0.8 | 1.3 | 1.6 | - | - | ○ | - | - |
| Comparative Example 6 | 1.8 | 0.8 | 0.9 | 1.5 | - | - | 1.6 | - | - | ○ | - | - |
| Comparative Example 7 | 2.6 | 0.6 | 0.4 | 2.0 | - | - | - | - | ○ | - | - | ○ |

[Table 1-3]

| | Film for substrate | Characteristics of resin layer | | | | Peel force test of EVA | | Peel force test of PVA | | Blocking |
|---|---|---|---|---|---|---|---|---|---|---|
| | | ΔP | P' | Glass transition temperature | Water droplet contact angle | 25°C | -20°C | 25°C | -20°C | |
| | | GPa | - | °C | ° | N/mm | N/mm | N/mm | N/mm | |
| Example 1 | Laminated film 1 | 0.8 | 2.1 | 41 | 72 | ⊙ | ⊙ | ⊙ | ⊙ | ⊙ |
| Example 2 | Laminated film 1 | 0.8 | 2.0 | 38 | 68 | ⊙ | ⊙ | ⊙ | ⊙ | ⊙ |
| Example 3 | Laminated film 1 | 1.2 | 2.5 | 39 | 70 | ⊙ | ⊙ | ⊙ | ⊙ | ⊙ |
| Example 4 | Laminated film 1 | 0.8 | 1.9 | 45 | 70 | ⊙ | ⊙ | ⊙ | ⊙ | ⊙ |
| Example 5 | Laminated film 1 | 1.0 | 2.3 | 41 | 69 | ⊙ | ⊙ | ⊙ | ⊙ | ⊙ |
| Example 6 | Laminated film 1 | 0.8 | 2.3 | 38 | 77 | ⊙ | ⊙ | ⊙ | ⊙ | ○ |
| Example 7 | Laminated film 1 | 0.3 | 1.3 | 45 | 69 | ○ | ○ | ○ | ○ | ⊙ |
| Example 8 | Laminated film 1 | 1.5 | 2.9 | 41 | 72 | ⊙ | ○ | ○ | ○ | ○ |
| Example 9 | Laminated film 1 | 1.7 | 2.1 | 45 | 60 | ○ | ○ | ⊙ | ○ | △ |
| Example 10 | Laminated film 1 | 1.5 | 2.2 | 43 | 63 | ○ | ○ | ⊙ | ○ | × |
| Example 11 | Laminated film 1 | 1.0 | 2.1 | 38 | 85 | ⊙ | ⊙ | ○ | ○ | ○ |
| Example 12 | Laminated film 1 | 1.0 | 2.4 | 35 | 91 | ○ | ○ | ○ | ○ | ○ |
| Example 13 | Laminated film 1 | 1.3 | 7.5 | 28 | 70 | ⊙ | ○ | ⊙ | ○ | ○ |
| Example 14 | Laminated film 1 | 1.4 | 8.0 | 25 | 65 | ⊙ | △ | ⊙ | △ | ○ |
| Example 15 | Laminated film 1 | 0.5 | 1.3 | 88 | 68 | ○ | ○ | ⊙ | ○ | ○ |
| Example 16 | Laminated film 1 | 0.2 | 1.1 | 75 | 70 | ○ | ○ | ⊙ | ○ | ⊙ |
| Example 17 | Laminated film 1 | 2.0 | 21.0 | 30 | 75 | ⊙ | ○ | ○ | ○ | ○ |
| Example 18 | Laminated film 1 | 0.1 | 1.1 | 35 | 83 | ○ | ○ | ○ | ○ | ⊙ |
| Example 19 | Laminated film 1 | 2.1 | 5.2 | 32 | 85 | ⊙ | △ | ⊙ | △ | ○ |
| Example 20 | Laminated film 1 | 0.3 | 1.2 | 70 | 73 | ⊙ | ○ | ⊙ | ⊙ | ⊙ |
| Example 21 | Laminated film 1 | 0.8 | 2.1 | 41 | 72 | ⊙ | ⊙ | ⊙ | ⊙ | ⊙ |
| Example 22 | Laminated film 1 | 0.1 | 1.1 | 77 | 72 | ○ | △ | ○ | △ | ⊙ |
| Example 23 | Laminated film 1 | 0.8 | 1.5 | 70 | 70 | ○ | ○ | ○ | ○ | × |
| Example 24 | Laminated film 1 | 1.3 | 2.3 | 40 | 63 | ○ | ○ | ⊙ | ⊙ | ○ |
| Example 25 | Laminated film 1 | 2.1 | 2.0 | 89 | 70 | ○ | △ | ○ | △ | ○ |
| Example 26 | Laminated film 1 | 1.0 | 2.7 | 38 | 75 | ⊙ | ⊙ | ⊙ | ○ | ⊙ |
| Example 27 | Laminated film 1 | 2.2 | 2.1 | 36 | 92 | ○ | △ | △ | △ | ○ |
| Example 28 | Laminated film 1 | 2.1 | 2.8 | 37 | 67 | ○ | △ | ○ | △ | ○ |
| Comparative Example 1 | Laminated film 1 | 2.3 | 2.8 | 37 | 67 | ○ | × | × | × | ○ |
| Comparative Example 2 | Laminated film 1 | 2.1 | 2.5 | 39 | 73 | ○ | × | × | × | ⊙ |
| Comparative Example 3 | Laminated film 1 | 2.2 | 2.8 | 30 | 70 | ○ | × | ○ | × | × |
| Comparative Example 4 | Laminated film 1 | 2.0 | 2.3 | 75 | 97 | ○ | × | × | × | ○ |
| Comparative Example 5 | Laminated film 1 | 2.1 | 2.4 | 88 | 53 | × | × | ○ | × | ○ |
| Comparative Example 6 | Laminated film 1 | 2.9 | 2.6 | 49 | 67 | × | × | × | × | ○ |
| Comparative Example 7 | Laminated film 1 | 3.4 | 3.6 | 81 | 67 | ○ | × | ○ | × | ○ |

[Table 2]

| | | Laminated film 1 | Laminated film 2 | Laminated film 3 | Laminated film 4 | Laminated film 5 | Laminated film 6 | Laminated film 7 | Laminated film 8 | Laminated film 9 |
|---|---|---|---|---|---|---|---|---|---|---|
| Layer structure of laminated film | Thermoplastic resin A | Resin 1 | Resin 1 | Resin 1 | Resin 1 | Resin 1 | Resin 1 | Resin 1 | Resin 1 | Resin 1 |
| | Thermoplastic resin 5 | Resin 2 | Resin 2 | Resin 3 | Resin 2 | | Resin 3 | Resin 4 | Resin 4 | Resin 2 |
| | Number of layers | 401 | 201 | 401 | 51 | 1 | 401 | 401 | 801 | 401 |
| Characteristics of laminated film | Band in which reflectance is 30% or more (nm) | 300 nm or more | 300 nm or more | 300 nm or more | 100 nm or more | No | 300 nm or more | 300 nm or more | 300 nm or more | 300 nm or more |
| | Average reflectance (%) in wavelength zone of 400 to 700 nm | 7 | 7 | 7 | 7 | 7 | 7 | 11 | 22 | 25 |
| | Average reflectance (%) in wavelength zone of 850 to 1200 nm | 80 | 71 | 95 | 73 | 9 | 97 | 15 | 15 | 25 |
| | Average transmittance (%) of visible light | 93 | 93 | 93 | 93 | 92 | 93 | 89 | 78 | 75 |
| | Average reflectance R20 (%) of P-polarized wave in wavelength zone of 500 to 700 nm on incidence at angle of 20° | 8 | 8 | 8 | 8 | 7 | 8 | 11 | 23 | 42 |
| | Average reflectance R40 (%) of P-polarazed wave in wavelength zone of 900 to 700 nm on incidence at angle of 40° | 4 | 4 | 4 | 4 | 3 | 4 | 15 | 35 | 43 |
| | Average reflectance R70 (%) of P-polarized wave in wavelength zone of 400 to 700 nm on incidence at angle of 70° | 20 | 17 | 23 | 18 | 9 | 22 | 47 | 73 | 45 |
| Characteristics of laminated film in X direction | Average rate of change (%) in shrinkage at 100°C to 150°C | 0.04 | 0.04 | 0.04 | 0.04 | 0.04 | 0.00 | 0.04 | 0.04 | 0.03 |

The number of layers in the table means the number of layers excluding the resin layer. The laminated film 5 is a single layer film because the resins A and B are the same. In Example 1 to 28, since only the composition of the resin composition was changed, the obtained laminated films had the same characteristics as those of laminated film 1 in Table 2.

(Examples 29 to 32 and 34 to 40)

laminated films (laminated films 2 to 5, 7, and 8) were produced under the same conditions as in Example 1 except that the number of laminated layers of the multilayer film used for a laminated film and the resin were changed as shown in Table 2. The characteristics of the resin layers of the resulting laminated films were the same as those in Example 1 shown in Tables 1-2 and 1-3. The evaluation results of the obtained laminated films are shown in Table 2. The evaluation results obtained when laminated glasses were produced using laminated films 2 to 5, 7, and 8 in the configurations shown in Tables 3 and 4 are shown in Tables 3 and 4.

(Example 33)

A laminated film (laminated film 6) was produced under the same conditions as in Example 1 except that the heat treatment temperature of the laminated film was changed to 235°C and the relaxation in the width direction was changed to 1.3%. The characteristics of the resin layer of the resulting laminated film were the same as those in Example 1 shown in Tables 1-2 and 1-3. The evaluation results of the obtained laminated film are shown in Table 2. The evaluation results of the laminated glass using laminated film 6 are shown in Table 3.

(Examples 41 to 44)

The evaluation results of the glass laminates using laminated films 7 and 8 are shown in Table 4.

(Example 45)

Resin 1 was used as a crystalline thermoplastic resin for constituting layer A (hereinafter, also referred to as resin A), and resin 2 was used as a thermoplastic resin for constituting layer B (hereinafter, also referred to as resin B). Resins A and B were melted at 280°C in separate extruders, and foreign matters and the like were removed through 5 sheets of FSS type leaf disk filters. Thereafter, while being metered by a gear pump such that the discharge ratio was resin A/resin B = 1/1.07, both resins were joined with a 401-layer feed block, and 401 layers in total of resin A and resin B were laminated alternately in the thickness direction such that the outermost layers on both sides were resin A. At this time, the layer thicknesses of layer A and layer B were designed such that the reflectance spectrum in the wavelength range of 380 nm to 1200 nm was flat. Then, the resulting molten laminate was fed to a T-die and molded into a sheet form, and then, while an electrostatic voltage of 8 kV was applied with a wire, the molded laminate was quenched and solidified on a casting drum having a surface temperature maintained at 25°C, and an unstretched film was thereby obtained. Both surfaces of this film were subjected to corona discharge treatment in air, and the resin composition was applied to the treated surfaces using a bar coater such that the application thickness was about 6 μm. Thereafter, the uniaxially stretched film was guided to a tenter with both edges in the width direction grasped with clips, stretched transversely under conditions of a temperature of 90°C and a magnification of 5.0 times, then subjected to heat treatment at 180°C, and further relaxed by 1.6% in the width direction, affording a laminated film having a thickness of 80 μm (laminated film 9). The resulting laminated film had polarization reflectivity to reflect 42% of P-polarized light and 10% of S-polarized light with respect to visible light to infrared light having a wavelength of 380 to 1200 nm. The characteristics of the resulting laminated film 9 are shown in Table 2, and the evaluation results of the laminated glass using laminated film 9 are shown in Table 4.

[Table 3]

| | Film for substrate | Thickness of intermediate layer | | | Thickness of glass | | | Heat shielding property | Appearance of laminated glass |
|---|---|---|---|---|---|---|---|---|---|
| | | d1 | d2 | d1/d2 | d3 | d4 | d3/d4 | | |
| Example 1 | Laminated film 1 | 380 | 380 | 1.0 | 2.1 | 2.1 | 1.0 | ○ | ○ |
| Example 29 | Laminated film 2 | 380 | 380 | 1.0 | 2.1 | 2.1 | 1.0 | △ | ○ |
| Example 30 | Laminated film 3 | 380 | 380 | 1.0 | 2.1 | 2.1 | 1.0 | ⊙ | ○ |
| Example 31 | Laminated film 4 | 380 | 380 | 1.0 | 2.1 | 2.1 | 1.0 | △ | ○ |
| Example 32 | Laminated film 5 | 380 | 380 | 1.0 | 2.1 | 2.1 | 1.0 | × | ○ |
| Example 33 | Laminated film 6 | 380 | 380 | 1.0 | 2.1 | 2.1 | 1.0 | ⊙ | × |

[Table 4]

| | Film for substrate | Thickness of intermediate layer | | | Thickness of glass | | | Display property | Double image | Appearance of laminated glass |
|---|---|---|---|---|---|---|---|---|---|---|
| | | d1 | d2 | d1/d2 | d3 | d4 | d3/d4 | | | |
| Example 32 | Laminated film 5 | 380 | 380 | 1.0 | 2.1 | 2.1 | 1.0 | × | - | ○ |
| Example 34 | Laminated film 7 | 380 | 380 | 1.0 | 2.1 | 2.1 | 1.0 | ○ | × | ○ |
| Example 35 | Laminated film 7 | 380 | 50 | 7.6 | 2.1 | 2.1 | 1.0 | ○ | ⊙ | ○ |
| Example 36 | Laminated film 7 | 760 | 50 | 15.2 | 2.1 | 2.1 | 1.0 | ○ | ⊙ | ○ |
| Example 37 | Laminated film 7 | 380 | 380 | 1.0 | 2.1 | 1.0 | 2.1 | ○ | ○ | ○ |
| Example 38 | Laminated film 7 | 380 | 380 | 1.0 | 4.0 | 1.0 | 4.0 | ○ | ○ | ○ |
| Example 39 | Laminated film 7 | 380 | 50 | 7.6 | 2.1 | 1.0 | 2.1 | ○ | ⊙ | ○ |
| Example 40 | Laminated film 8 | 380 | 50 | 7.6 | 2.1 | 1.0 | 2.1 | ⊙ | ⊙ | ○ |
| Example 41 | Laminated film 7 | - | 380 | - | 2.1 | - | - | ○ | ○ | - |
| Example 42 | Laminated film 7 | - | 50 | - | 2.1 | - | - | ○ | ⊙ | - |
| Example 43 | Laminated film 7 | - | 380 | - | 2.1 | - | - | ⊙ | ○ | - |
| Example 44 | Laminated film 8 | - | 50 | - | 2.1 | - | - | ⊙ | ⊙ | - |
| Example 45 | Laminated film 9 | 380 | 380 | 1.0 | 2.1 | 1.0 | 2.1 | ○ | ○ | × |

INDUSTRIAL APPLICABILITY

By the present invention, it is possible to provide a laminated film which is superior in versatile adhesiveness to various functional materials and has high adhesiveness to functional materials regardless of the temperature at which the laminated film is used, in particular, in a low temperature environment (below freezing point). Since the laminated film of the present invention is superior in the characteristics described above, it can be suitably used for solar battery members, laminated glass, polarizer protective films, etc.

## Claims

1. A laminated film comprising a resin layer on at least one surface, wherein the resin layer satisfies at least one of features A to C described below, and when positive secondary ion normalized intensities of GCIB-TOF-SIMS of each component at positions of 20% and 50% of a thickness from a surface layer of the resin layer are denoted by Xs and Xc, respectively, $0.5 \leq Xs/Xc \leq 2.0$ is satisfied for all components:

   Feature A: All of an acrylic resin, a polyester resin and a urethane resin are contained;
   Feature B: An acrylic modified polyester resin and a urethane resin are contained; and
   Feature C: all of an acrylic skeleton, a polyester skeleton and a urethane skeleton are contained.

2. The laminated film according to claim 1, wherein the resin layer contains a chemical structure derived from an oxazoline compound.

3. The laminated film according to claim 1 or 2, wherein the resin layer contains an oxazoline compound.

4. The laminated film according to claim 2 or 3, wherein when positive secondary ion normalized intensities of GCIB-TOF-SIMS of the oxazoline compound at the surface layer and the position of 20% of the thickness of the resin layer are XO and XOs, respectively, $XO/Xs \geq 1.0$ is satisfied.

**5.** The laminated film according to any one of claims 1 to 4, wherein when an AFM elastic modulus of the resin layer at a temperature T°C is denoted by P(T), P(-20) - P(25) is denoted by ΔP, and P(-20)/P(25) is denoted by an elastic modulus ratio P', the laminated film has at least one of features 1 and 2:

Feature 1: the ΔP is 0.2 GPa or more and 2.0 GPa or less; and
Feature 2: the elastic modulus ratio P' is 0.1 or more and 2.3 or less.

**6.** The laminated film according to any one of claims 1 to 5, wherein the resin layer has a glass transition temperature of 30°C or higher and 80°C or lower.

**7.** The laminated film according to any one of claims 1 to 6, wherein the resin layer has a water droplet contact angle of 65° or more and 90° or less.

**8.** The laminated film according to any one of claims 1 to 7, wherein the resin layer has at least one or more of structures of formulas (1) to (5):

[Chem. 1]

Formula (1) 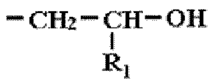 $R_1$: H or $CH_3$

Formula (2) 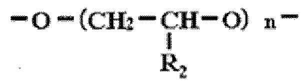

$R_2$: H or $CH_3$, n: positive integer

Formula (3) 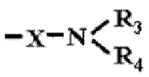

X: -C(=O)- or $CH_2$

$R_3$, $R_4$: H, $CH_3$, $C_2H_5$, $CH(CH_3)_2$ or $CH_2OH$

Formula (4) 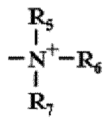

$R_5$, $R_6$, $R_7$: $CH_3$ or $C_2H_5$

Formula (5) 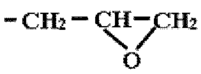

.

**9.** The laminated film according to any one of claims 1 to 8, wherein the resin layer contains a melamine compound.

**10.** The laminated film according to any one of claims 1 to 9, wherein when positive secondary ion normalized intensity of GCIB-TOF-SIMS of each component at a position of 80% of the thickness from the surface layer of the resin layer is Xb, $0.5 \leq Xb/Xc \leq 2.0$ is satisfied for all components.

**11.** The laminated film according to any one of claims 1 to 10, comprising a laminated structure unit in which 51 or more layers including at least a layer (layer A) a main component of which is a polyester resin (resin A) and a layer (layer B) a main component of which is a thermoplastic resin (resin B) differing from the resin A are laminated.

**12.** The laminated film according to any one of claims 1 to 11, wherein on at least one surface thereof, the laminated film has at least one reflection band in which a reflectance of 30% or more continues over a wavelength width of 20 nm or more when light having a wavelength of 300 nm to 2500 nm is incident at an incident angle of 10°.

**13.** The laminated film according to any one of claims 1 to 12, wherein on at least one surface thereof, when light is incident at an incident angle of 10°, an average reflectance in a band with a wavelength of 400 nm to 700 nm is 15% or less, and an average reflectance in a band with a wavelength of 850 nm to 1200 nm is 70% or more.

**14.** The laminated film according to any one of claims 1 to 12, wherein on at least one surface thereof, an average transmittance of visible light normally incident is 50% or more and 100% or less, and when average reflectances (%) of a P-polarized wave having a wavelength of 400 nm to 700 nm attained when P-polarized wave light is incident at angles of 20°, 40° and 70° with respect to a normal line to a film surface are denoted by R20, R40 and R70, a relationship of R20 ≤ R40 < R70 is satisfied.

**15.** The laminated film according to any one of claims 1 to 14, wherein when a direction parallel to a film surface and largest in average rate of change in thermal shrinkage measured by thermomechanical analysis in a range of 100°C to 150°C is defined as an X direction, the average rate of change in thermal shrinkage in the X direction is 0.01%/°C or more and 0.1%/°C or less.

**16.** A solar battery module having a configuration in which the laminated film according to any one of claims 1 to 15 and a sealant are directly laminated.

**17.** The solar battery module according to claim 16, wherein the solar battery module has two sealants (sealants 1 and 2), and includes the sealant 1, a solar battery cell, the sealant 2, and the laminated film in this order.

**18.** A glass component comprising the laminated film according to any one of claims 1 to 15, an intermediate layer, and glass, wherein the laminated film and the intermediate layer are adjacent to each other.

**19.** A glass component having two glass (glass 1, 2) and two intermediate layers (intermediate layers 1, 2), and including the glass 1, the intermediate layer 1, the laminated film according to any one of claims 1 to 15, the intermediate layer 2, and the glass 2 in this order.

**20.** The glass component according to claim 19, wherein when a thickness of the intermediate layer 1 is denoted by d1, and a thickness of the intermediate layer 2 is denoted by d2, $3 \leq d1/d2 \leq 100$ is satisfied.

**21.** The glass component according to claim 19 or 20, wherein when a thickness of the glass 1 is denoted by d3 and a thickness of the glass 2 is denoted by d4, $1.5 \leq d3/d4 \leq 10$ is satisfied.

**22.** An automobile comprising the glass component according to any of claims 18 to 21.

**23.** A building window comprising the glass component according to any of claims 18 to 21.

**INTERNATIONAL SEARCH REPORT**

International application No. **PCT/JP2023/022293**

**A. CLASSIFICATION OF SUBJECT MATTER**

***B32B 27/30***(2006.01)i; ***B32B 27/36***(2006.01)i; ***B32B 27/40***(2006.01)i; ***C08F 2/44***(2006.01)i; ***C08F 283/02***(2006.01)i; ***C08J 7/043***(2020.01)i
FI: B32B27/30 A; B32B27/36; B32B27/40; C08F2/44 C; C08F283/02; C08J7/043 CEX

According to International Patent Classification (IPC) or to both national classification and IPC

**B. FIELDS SEARCHED**

Minimum documentation searched (classification system followed by classification symbols)

B32B1/00-43/00; C08J5/00-5/02; C08F2/44; C08F283/02; C08J5/12-5/22; C08J7/043; C08K3/00-13/08; C08L1/00-101/14; C09J1/00-5/10; C09J9/00-201/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 2016/052133 A1 (TORAY INDUSTRIES, INC.) 07 April 2016 (2016-04-07) claims 1, 3-6, 10, paragraphs [0006], [0125]-[0147], table 1, examples | 1-10, 16-17<br>11-15, 18-23 |
| Y | WO 2014/156726 A1 (TORAY INDUSTRIES, INC.) 02 October 2014 (2014-10-02) claims 1, 6, 13, paragraphs [0001]-[0002], [0004], [0087]-[0089], [0111]-[0115], [0140] | 11-15, 18-23 |
| A | WO 2014/024570 A1 (TORAY INDUSTRIES, INC.) 13 February 2014 (2014-02-13) claims 1-2, examples | 1-23 |
| A | JP 2014-144600 A (MITSUBISHI PLASTICS INC) 14 August 2014 (2014-08-14) claim 1, paragraphs [0035], [0055], examples | 1-23 |
| A | JP 2007-301982 A (TORAY INDUSTRIES, INC.) 22 November 2007 (2007-11-22) claim 1, examples | 1-23 |
| A | JP 2016-064974 A (TORAY INDUSTRIES, INC.) 28 April 2016 (2016-04-28) claim 1, paragraph [0035], examples | 1-23 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **22 August 2023** | **05 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/022293**

| Patent document cited in search report | Publication date (day/month/year) | Patent family member(s) | Publication date (day/month/year) |
|---|---|---|---|
| WO 2016/052133 A1 | 07 April 2016 | TW 201613763 A | |
| WO 2014/156726 A1 | 02 October 2014 | US 2016/0001530 A1<br>claims 1, 6, 13, paragraphs [0001]-[0007], [0016], [0107]-[0109], [0133]-[0143], [0169] | |
| WO 2014/024570 A1 | 13 February 2014 | US 2015/0191621 A1<br>claims 1-2, examples | |
| JP 2014-144600 A | 14 August 2014 | (Family: none) | |
| JP 2007-301982 A | 22 November 2007 | (Family: none) | |
| JP 2016-064974 A | 28 April 2016 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000336309 A
- JP 2001179913 A
- JP 2011156848 A
- JP 2007307893 A